# EUROPÄISCHE PATENTSCHRIFT

(11) **EP 1 267 390 B1**
(45) Veröffentlichungstag und Bekanntmachung des Hinweises auf die Patenterteilung: **07.04.2010**
(21) Anmeldenummer: 02100696.0
(22) Anmeldetag: 12.06.2002
(51) Int. Cl.: H01L 21/00

(54) **Verfahren zum Umsetzen eines im wesentlichen scheibenförmigen Werkstücks sowie Vorrichtung zum Durchführen dieses Verfahrens**
Method of transferring a substantially disk-shaped workpiece and apparatus for carrying out such a transfer
Procédé de transfert d'une pièce en forme essentiellement de disque et dispositif pour effectuer d'un tel transfert

(30) Priorität: 15.06.2001 DE 10128924
(43) Veröffentlichungstag der Anmeldung: 18.12.2002
(73) Patentinhaber: NXP B.V., 5656 AG Eindhoven (NL)
(72) Erfinder: Anker, Joachim, 52066 Aachen (DE)
(74) Vertreter: Krott, Michel

(56) Entgegenhaltungen:
- EP-A- 0 999 583
- EP-A- 1 041 624
- US-A- 5 224 581
- US-A- 5 476 566

## Beschreibung

Die Erfindung bezieht sich auf ein Verfahren gemäß dem Anspruch 1 zum Umsetzen eines im wesentlichen scheibenförmigen Werkstücks. Die Erfindung bezieht sich ferner auf eine Vorrichtung gemäß dem Anspruch 13 zum Durchführen eines derartigen Verfahrens.

Bei der einseitigen oder beidseitigen Oberflächenbearbeitung von im wesentlichen ebenen, insbesondere sehr dünnen und spröden Werkstücken bietet sich zur Durchführung dieser Bearbeitung ein vorübergehendes Aufkleben auf sogenannte Werkstückträger, insbesondere Trägerscheiben oder Trägerplatten, an, um eine Verformung der Werkstücke oder gar einen Bruch derselben zu vermeiden. Als sehr dünnes Werkstück soll in diesem Zusammenhang ein solches Werkstück verstanden werden, bei dem die Dicke klein ist gegenüber der Länge, Breite oder dem Durchmesser.

Aus der deutschen Offenlegungsschrift 198 50 873 ist ein Verfahren zum Bearbeiten eines im wesentlichen scheibenförmigen Erzeugnisses der Halbleitertechnik bekannt, welches entlang wenigstens einer ersten Hauptfläche eine Anzahl von elektronischen Schaltungskörpern sowie eine der ersten Hauptfläche gegenüberliegende zweite Hauptfläche aufweist. Bei diesem Verfahren wird zur Durchführung von Bearbeitungsvorgängen, die eine der Hauptflächen des Erzeugnisses betreffen, auf der gegenüberliegenden Hauptfläche des Erzeugnisses ein schichtförmiges, adhäsives Material flächig aufgebracht, auf welches ein wenigstens weitgehend formstabiles Trägerelement zur flächigen Verbindung mit dieser gegenüberliegenden Hauptfläche des Erzeugnisses aufgebracht wird.

Es wird außerdem auf den folgenden Stand der Technik in den Patenschriften EP-A- 1041624 und -A-5,476,566 Bezug genommen.

Die Erfindung hat die Aufgabe, ein Verfahren zu schaffen, mit dem ein einfaches und kostengünstiges Umsetzen eines Werkstücks der genannten Art von einem ersten Werkstückträger auf einen zweiten Werkstückträger ermöglicht wird. Die Erfindung hat ferner die Aufgabe, eine Vorrichtung zur Durchführung eines derartigen Verfahrens zu schaffen.

Erfindungsgemäß wird diese Aufgabe gelöst durch ein Verfahren zum Umsetzen eines im wesentlichen scheibenförmigen Werkstücks von einem ersten Werkstückträger, auf welchem das Werkstück entlang einer ersten seiner Hauptflächen mittels einer ersten Klebung wenigstens weitgehend flächig haftend verbunden ist, auf einen zweiten Werkstückträger, wobei das erfindungsgemäße Verfahren die folgenden Verfahrensstufen umfaßt:
- Befestigen des zweiten Werkstückträgers wenigstens weitgehend flächig haftend auf einer der ersten Hauptfläche des Werkstücks gegenüberliegenden zweiten seiner Hauptflächen mittels einer zweiten Klebung, deren Haftkraft deutlich größer ist als die Haftkraft der ersten Klebung,
- Befestigen des ersten Werkstückträgers an einer ersten Haltevorrichtung,
- Befestigen des zweiten Werkstückträgers an einer zweiten Haltevorrichtung,
- Trennen des Werkstücks vom ersten Werkstückträger entlang der ersten Klebung durch Aufbringen einer zu den Hauptflächen des Werkstücks wenigstens teilweise senkrechten Zugkraft zwischen der ersten und der zweiten Haltevorrichtung,
- Trennen des ersten Werkstückträgers von der ersten Haltevorrichtung sowie
- Trennen des zweiten Werkstückträgers mitsamt dem damit verbundenen Werkstück von der zweiten Haltevorrichtung.

Zu Beginn der erfindungsgemäßen Verfahrensschritte befindet sich somit das Werkstück auf dem ersten Werkstückträger, auf dem es entlang seiner ersten Hauptfläche mit Hilfe der ersten Klebung befestigt ist. Von diesem ersten Werkstückträger wird das Werkstück in Durchführung des erfindungsgemäßen Verfahrens auf einen zweiten Werkstückträger umgesetzt, auf dem es abschließend entlang seiner zweiten Hauptfläche wenigstens weitgehend flächig haftend angeordnet ist. Die Verbindung zwischen der zweiten Hauptfläche des Werkstücks und dem zweiten Werkstückträger erfolgt dabei durch die zweite Klebung, und da deren Haftkraft deutlich größer ist als die Haftkraft der ersten Klebung, wird die erste Klebung beim Aufbringen der Zugkraft zwischen den Haltevorrichtungen sicher aufgetrennt, während die zweite Klebung das Werkstück auf dem zweiten Werkstückträger festhält. Die Haltevorrichtungen dienen dabei der Übertragung der Zugkraft auf die Werkstückträger und werden nach erfolgtem Umsetzen des Werkstücks wieder von den Werkstückträgern getrennt.

Durch das erfindungsgemäße Verfahren wird es auf kostengünstige und einfache Weise möglich, auch mechanisch empfindliche Werkstücke schonend von einem Werkstückträger auf einen anderen umzusetzen. Eine gesonderte Behandlung der ersten Klebung zur Veränderung der Haftkraft vor dem Umsetzen des Werkstücks ist nicht erforderlich.

Dabei können insbesondere wenigstens weitgehend starr ausgebildete Werkstückträger verwendet werden.

Die Befestigung der Werkstückträger an den Haltevorrichtungen kann wahlweise durch Klebungen bzw. durch magnetische Kräfte vorgenommen werden. Diese Klebungen bzw. magnetischen Kräfte weisen Haftkräfte zwischen den Werkstückträgern und den Haltevorrichtungen auf, die deutlich größer sind als die Haftkraft der ersten Klebung, so dass beim Aufbringen der Zugkraft die Werkstückträger sicher mit den Haltevorrichtungen verbunden bleiben.

Zum Trennen der Werkstückträger von den Haltevorrichtungen nach dem Umsetzen des Werkstücks wird bevorzugt eine von wenigstens einer der Haltevorrichtungen umfaßte Auswurfvorrichtung verwendet. Diese bedient sich zur Durchführung des Trennvorgangs vorteilhaft wenigstens eines Auswerferstifts oder einer Druckgaseinrichtung zum ausüben eines Drucks auf das abzulösende Werkstück.

Nach einer anderen, vorteilhaften Ausgestaltung des erfindungsgemäßen Verfahrens wird bei wenigstens einer der Haltevorrichtungen, an der das Befestigen des Werkstückträgers mit einer Magnetvorrichtung vorgenommen wird, der Werkstückträger auf einem gegenüber der Magnetvorrichtung bewegbaren, im wesentlichen flächig ausgestalteten Auflageelement angeordnet. Zum Trennen des Werkstückträgers von der Haltevorrichtung wird das Auflageelement gemeinsam mit dem Werkstückträger aus dem Wirkungsbereich der Magnetvorrichtung herausbewegt. Dieses Herausbewegen kann vorzugsweise dadurch bewerkstelligt werden, dass wenigstens einer der Werkstückträger auf einem abrollbaren, flachbandförmigen, vorzugsweise aus Stahl gebildeten ersten Auflageelement angeordnet wird und der Werkstückträger zum Trennen von der Haltevorrichtung durch Abrollen des flachbandförmigen ersten Auflageelements auf ein flachbandförmiges zweites Auflageelement umgesetzt wird.
Weitere Ausgestaltungen und Einzelheiten des erfindungsgemäßen Verfahrens sind in den vom Patentanspruch 1 abhängigen Ansprüchen wiedergegeben.

Zur Durchrührung des erfindungsgemäßen Verfahrens wird ferner eine Vorrichtung geschaffen zum Umsetzen eines im wesentlichen scheibenförmigen Werkstücks von einem ersten Werkstückträger, auf welchem das Werkstück entlang einer ersten seiner Hauptflächen mittels einer ersten Klebung wenigstens weitgehend flächig haftend verbunden ist, auf einen zweiten Werkstückträger, auf dem das Werkstück wenigstens weitgehend flächig haftend auf einer der ersten Hauptfläche des Werkstücks gegenüberliegenden zweiten seiner Hauptflächen mittels einer zweiten Klebung, deren Haftkraft deutlich größer ist als die Haftkraft der ersten Klebung, aufzubringen und zu befestigen ist. Neben den Werkstückträgern zum Befestigen des Werkstücks umfaßt die erfindungsgemäße Vorrichtung weiterhin eine erste Haltevorrichtung zum Befestigen des ersten Werkstückträgers an dieser ersten Haltevorrichtung und eine zweite Haltevorrichtung zum Befestigen des zweiten Werkstückträgers an dieser zweiten Haltevorrichtung.

Mit einer Vorrichtung der erfindungsgemäßen Art läßt sich bevorzugt ein Werkstück behandeln, welches ein Erzeugnis der Halbleitertechnik ist, vorzugsweise eine Halbleiterscheibe, und welches weiterhin bevorzugt entlang wenigstens seiner zweiten Hauptfläche zur Ausbildung einer Anzahl von im wssentlichen senkrecht zu der zweiten Hauptfläche mechanisch zu trennenden, elektronischen Schaltungskörpern gestaltet ist. Die Erfindung ermöglicht dann durch das mit ihr vornehmbare Umsetzen in einfacher Weise eine Bereitstellung des Werkstücks auf dem zweiten Werkstückträger zu einer nachfolgenden Bearbeitung seiner ersten Hauptfläche, beispielsweise in einer Arbeitsstufe zum Abdünnen, zur Beschichtung oder dergleichen.

Weitere Ausgestaltungen und Einzelheiten der erfindungsgemäßen Vorrichtung sind in den dem unabhängigen Patentanspruch 13 nachgeordneten Ansprüchen wiedergegeben.

Die erfindungsgemäße Vorrichtung ist einfach aufgebaut und ermöglicht eine sichere, kostengünstige und damit rationelle Fertigung.

Ein Ausführungsbeispiel der Erfindung ist in der Zeichnung dargestellt und wird im Nachfolgenden näher beschrieben. Es zeigen
- Fig. 1: ein Beispiel für ein mit einer ersten Klebung auf einem ersten Werkstückträger befestigtes Werkstück in schematischer Darstellung,
- Fig. 2: den Werkstückträger mit dem Werkstück gemäß Fig. 1 nach Befestigen eines zweiten Werkstückträgers auf dem Werkstück gegenüber dem ersten Werkstückträger in schematischer Darstellung,
- Fig. 3: das Werkstück mit den beiden Werkstückträgern gemäß Fig. 2 nach Befestigen des ersten Werkstückträgers an einer ersten Haltevorrichtung und des zweiten Werkstückträgers an einer zwiten Haltevorrichtung gemäß einem ersten Ausführungsbeispiel in schematischer Darstellung,
- Fig. 4: eine schematische Explosionsdarstellung der Anordnung nach Fig. 3,
- Fig. 5: die Anordnung nach Fig. 3 nach Trennen des Werkstücks vom ersten Werkstückträger,
- Fig. 6: die Anordnung nach Fig. 3 und 5 nach zusätzlichem Trennen des ersten Werkstückträgers von der ersten Haltevorrichtung und des zweiten Werkstückträgers mitsamt dem damit verbundenen Werkstück von der zweiten Haltevorrichtung,
- Fig. 7: eine schematische Darstellung einer Abwandlung der Anordnung nach Fig. 3 gemäß einem zweiten Ausführungsbeispiel,
- Fig. 8: die Anordnung nach Fig. 7 nach Trennen des Werkstücks vom ersten Werkstückträger,
- Fig. 9: die Anordnung nach Fig. 7 und 8 nach zusätzlichem Trennen des ersten Werkstückträgers von der ersten Haltevorrichtung und des zweiten Werkstückträgers mitsamt dem damit verbundenen Werkstück von der zweiten Haltevorrichtung,
- Fig. 10: eine schematische Darstellung einer Draufsicht auf die erste oder die zweite Haltevorrichtung gemäß dem ersten oder zweiten Ausführungsbeispiel,
- Fig. 11: eine Abwandlung der Anordnung nach Fig. 9 gemäß einem dritten Ausführungsbeispiel,
- Fig. 12: eine schematische Darstellung einer Ausgestaltung einer der Haltevorrichtungen in Ausbildung mit einer Magnetvorrichtung und flachbandförmigen, abrollbaren Auflageelementen gemäß einem vierten Ausführungsbeispiel,
- Fig. 13: eine schematische Darstellung einer Draufsicht auf die Anordnung nach Fig. 12 und
- Fig. 14: die Anordnung nach Fig. 12 und 13 während des Abrollens eines der Werkstückträger in schematischer Darstellung.

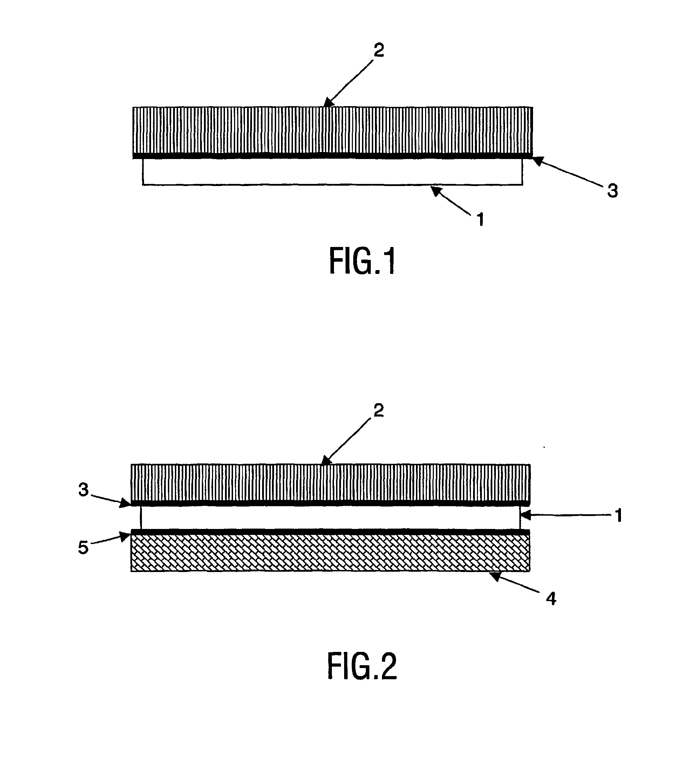

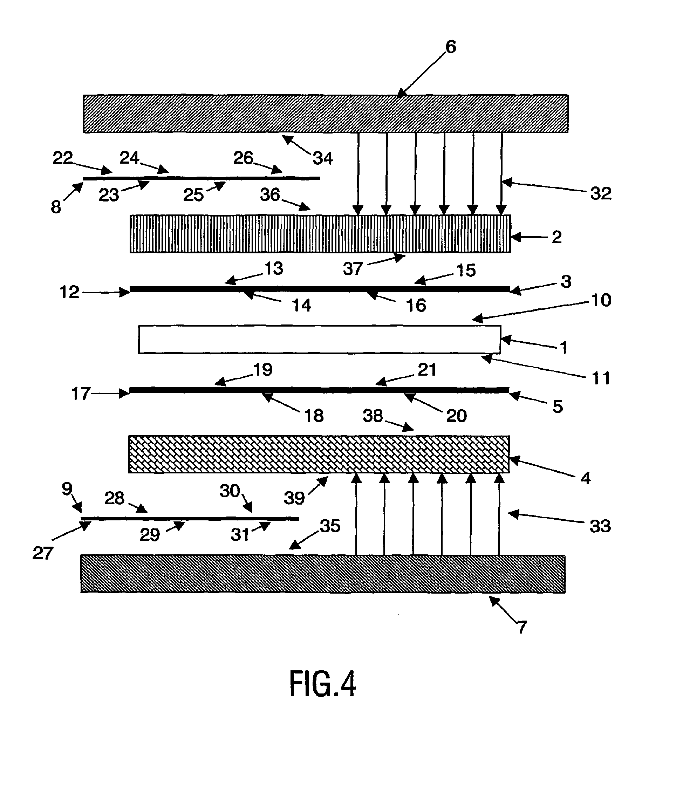

In der schematischen Darstellung nach Figur 1 ist ein im wesentlichen scheibenförmiges Werkstück 1, insbesondere eine dünne Halbleiterscheibe, flächig entlang ihrer ersten Hauptfläche, die in der dargestellten Lage des Werkstücks 1 dessen Oberseite bildet, mit Hilfe einer ersten Klebung 3 auf einem ersten, wenigstens weitgehend starr ausgebildeten Werkstückträger 2 befestigt. Die erste Klebung 3 wird vorzugsweise mit einer als erste doppelseitig klebende Folie 3 ausgebildeten, ersten Klebeschicht vorgenommen. Diese erste doppelseitig klebende Folie 3 besteht in an sich bekannter Weise aus einem folienförmigen Kunststoffkörper, dessen beide Flächen mit Klebstoffschichten bedeckt sind. Dabei ist eine erste dieser Flächen mit einer ersten Klebstoffschicht dem ersten Werkstückträger 2 und eine zweite dieser Flächen mit einer zweiten Klebstoffschicht dem Werkstück 1 zugewandt. Eine Darstellung dieser Zuordnung findet sich in Figur 4.

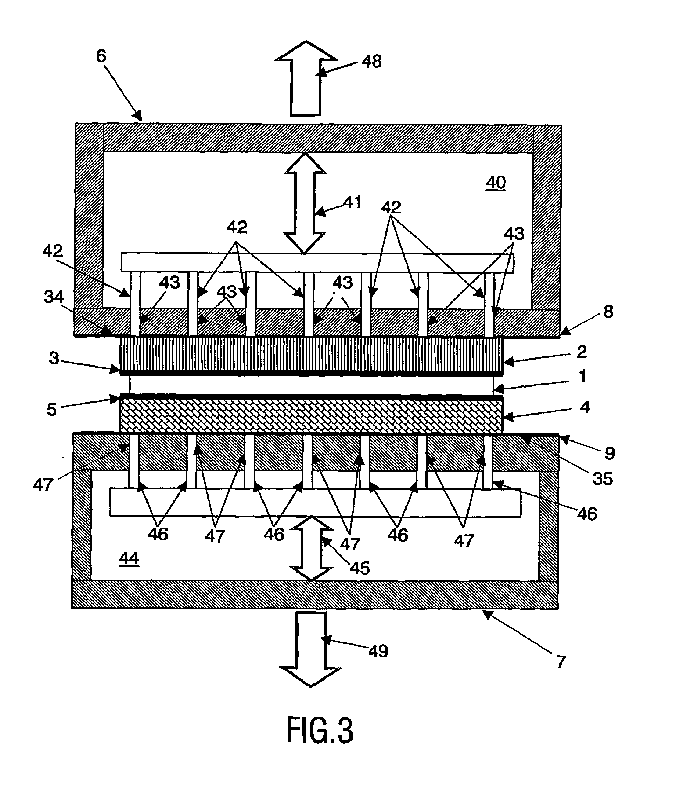

Die Darstellung der Fig. 2 zeigt schematisch den nächsten Verfahrensschritt. Darin werden das Werkstück 1 und der erste Werkstückträger 2 wenigstens weitgehend flächig haftend auf einer zweiten Hauptfläche des Werkstücks 1, die der ersten Hauptfläche gegenüberliegt und in der dargestellten Lage des Werkstücks 1 dessen Unterseite bildet, mit Hilfe einer zweiten Klebung 5 auf einem zweiten, wenigstens weitgehend starr ausgebildeten Werkstückträger 4 befestigt. Die Haftkraft der zweiten Klebung 5 ist deutlich größer als die Haftkraft der ersten Klebung 3. Auch die zweite Klebung 5 wird vorzugsweise mit einer als doppelseitig klebende Folie ausgebildeten Klebeschicht vorgenommen; diese im Folgenden als zweite Klebeschicht bezeichnete Klebeschicht wird durch eine zweite doppelseitig klebende Folie gebildet. Die zweite doppelseitig klebende Folie 5 besteht ebenfalls in an sich bekannter Weise aus einem folienförmigen Kunststoffkörper, dessen beide Flächen mit Klebstoffschichten bedeckt sind. Dabei ist eine erste dieser Flächen mit einer dritten Klebstoffschicht dem zweiten Werkstückträger 4 und eine zweite dieser Flächen mit einer vierten Klebstoffschicht dem Werkstück 1 zugewandt. Eine Darstellung dieser Zuordnung findet sich wieder in Figur 4. Fig. 3 zeigt in einem ersten Ausführungsbeispiel, wie die in Fig. 2 schematisch dargestellte Anordnung aus Werkstück 1, Werkstückträgern 2, 4 und sie verbindenden Klebungen 3, 5 zwischen zwei Haltevorrichtungen angeordnet wird. Darin ist an einer ersten dieser Haltevorrichtungen mit dem Bezugszeichen 6 der erste Werkstückträger 2 und an einer zweiten dieser Haltevorrichtungen mit dem Bezugszeichen 7 der zweite Werkstückträger 4 befestigt. Die Befestigung des ersten Werkstückträgers 2 an der ersten Haltevorrichtung 6 erfolgt in diesem ersten Ausführungsbeispiel mit Hilfe einer dritten Klebung 8, und die Befestigung des zweiten Werkstückträgers 4 an der zweiten Haltevorrichtung 7 erfolgt mit Hilfe einer vierten Klebung 9. Die Haftkräfte der dritten Klebung 8 zwischen dem ersten Werkstückträger 2 und der ersten Haltevorrichtung 6 sowie der vierten Klebung 9 zwischen dem zweiten Werkstückträger 4 und der zweiten Haltevorrichtung 7 sind deutlich größer als die Haftkraft der ersten Klebung 3 und auch größer als die Haftkraft der zweiten Klebung 5. Dadurch wird sichergestellt, dass beim Trennvorgang die erste Klebung 3 zuerst aufgetrennt wird.

Die dritte und die vierte Klebung 8,9 können wieder bevorzugt mit doppelseitig klebenden Folien - einer dritten und einer vierten doppelseitig klebenden Folie - vorgenommen werden. Jede dieser doppelseitig klebenden Folien 8 und 9 besteht wieder aus einem folienförmigen Kunststoffkörper, dessen beide Flächen mit Klebstoffschichten bedeckt sind. Dabei ist eine erste dieser Flächen der dritten doppelseitig klebenden Folie 8 mit einer fünften Klebstoffschicht dem ersten Werkstückträger 2 und eine zweite dieser Flächen der dritten doppelseitig klebenden Folie 8 mit einer sechsten Klebstoffschicht der ersten Haltevorrichtung 6 zugewandt. Entsprechend ist eine erste dieser Flächen der vierten doppelseitig klebenden Folie 9 mit einer siebten Klebstoffschicht dem zweiten Werkstückträger 4 und eine zweite dieser Flächen der vierten doppelseitig klebenden Folie 9 mit einer achten Klebstoffschicht der zweiten Haltevorrichtung 7 zugewandt Eine Darstellung dieser Zuordnung findet sich in Figur 4.

In Fig. 4 sind in schematischer Darstellung die vorgenannten Flächen und Klebstoffschichten in ihrer Zuordnung zueinander näher bezeichnet. Darin sind neben den in der voraufgehenden Beschreibung bereits mit Bezugszeichen versehenen Elementen, deren Bezugszeichen unverändert beibehalten sind, die folgenden weiteren Elemente mit den nachstehend genannten Bezugszeichen skizziert: die erste Hauptfläche 10 und die zweite Hauptfläche 11 des Werkstücks 1; der Kunststoffkörper 12, die erste Fläche 13 mit der ersten Klebstoffschicht 15 und die zweite Fläche 14 mit der zweiten Klebstoffschicht 16 der ersten doppelseitig klebenden Folie 3; der Kunststoffkörper 17, die erste Fläche 18 mit der dritten Klebstoffschicht 20 und die zweite Fläche 19 mit der vierten Klebstoffschicht 21 der zweiten doppelseitig klebenden Folie 5; der Kunststoffkörper 22, die erste Fläche 23 mit der fünften Klebstoffschicht 25 und die zweite Fläche 24 mit der sechsten Klebstoffschicht 26 der dritten doppelseitig klebenden Folie 8; der Kunststoffkörper 27, die erste Fläche 28 mit der siebten Klebstoffschicht 30 und die zweite Fläche 29 mit der achten Klebstoffschicht 31 der vierten doppelseitig klebenden Folie 9.

Bei einer Ausbildung der ersten Klebung als erste doppelseitig klebende Folie 3 weist bevorzugt die zweite Klebstoffschicht 16 gegenüber dem Werkstück 1 die schwächste Haftkraft auf, wodurch beim Trennen des Werkstücks 1 vom ersten Werkstückträger 2 diese erste doppelseitig klebende Folie 3 auf dem ersten Werkstückträger 2 verbleibt und somit das Werkstück 1 freigibt.

Zur schematischen Darstellung einer Ausgsstaltung wenigstens einer der Haltevorrichtungen 6, 7 in Ausbildung mit einer Magnetvorrichtung ist in Fig. 4 ferner an Stelle der dritten Klebung 8 ein Magnetfeld 32 zwischen der ersten Haltevorrichtung 6 und dem ersten Werkstückträger 2 und an Stelle der vierten Klebung 9 ein Magnetfeld 33 zwischen der zweiten Haltevorrichtung 7 und dem zweiten Werkstückträger 4 eingezeichnet. Dazu sind die Werkstückträger 2,4 mit ferromagnetischem Werkstoff ausgebildet. Die Haltevorrichtungen 6, 7 weisen eine wahlweise wirksam oder wirkungslos einstellbare erste bzw. zweite Magnetvorrichtung zum Befestigen der zugeordneten Werkstückträger 2 bzw. 4 an den Haltevorrichtungen mit Hilfe magnetischer Anziehung auf. Die dabei auftretenden magnetischen Kräfte zwischen der Haltevorrichtung 6 bzw. 7 und dem zugeordneten Werkstückträger 2 bzw. 4 sind deutlich größer gewählt als die Haftkraft der ersten Klebung 3. Ein Ausführungsbeispiel einer derart ausgestalteten Haltevorrichtung ist in einigen der nachfolgend beschriebenen Figuren dargestellt.

In Fig. 4 sind ferner zur Orientierung die folgenden Elemente bezeichnet: Eine Fläche 34 der ersten Haltevorrichtung 6, entlang derer die erste Haltevorrichtung 6 mit dem ersten Werkstückträger 2 wenigstens weitgehend flächig verbunden wird; eine Fläche 35 der zweiten Haltevorrichtung 7, entlang derer die zweite Haltevorrichtung 7 mit dem zweiten Werkstückträger 4 wenigstens weitgehend flächig verbunden wird; eine Fläche 36 des ersten Werkstückträgers 2, entlang derer der erste Werkstückträger 2 mit der Fläche 34 der ersten Haltevorrichtung 6 wenigstens weitgehend flächig verbunden wird; eine Fläche 37 des ersten Werkstückträgers 2, entlang derer der erste Werkstückträger 2 mit der ersten Hauptfläche 10 des Werkstücks 1 wenigstens weitgehend flächig verbunden wird; eine Flä-che 38 des zweiten Werkstückträgers 4, entlang derer der zweite Werkstückträger 4 mit der zweiten Hauptfläche 11 des Werkstücks 1wenigstens weitgehend flächig verbunden wird; und eine Fläche 39 des zweiten Werkstückträgers 4, entlang derer der zweite Werkstück-träger 4 mit der Fläche 35 der zweiten Haltevorrichtung 7 wenigstens weitgehend flächig verbunden wird.

In dem ersten Ausführungsbeispiel nach Fig. 3, in dem der erste Werkstückträger 2 mittels der dritten Klebung 8 an der ersten Haltevorrichtung 6 und der zweite Werkstückträger 4 mittels der vierten Klebung 9 an der zweiten Haltevorrichtung 7 befestigt ist, umfaßt die erste Haltevorrichtung 6 eine erste Auswurfvorrichtung 40. Diese ist mit einem Druckstempel 41 und Auswerferstiften 42 ausgebildet. Die Auswerferstifte 42 sind durch Ausnehmungen (beispielsweise Bohrungen) 43 in der dem ersten Werkstückträger 2 zugewandten Fläche 34 geführt, so dass sie mit dem ersten Werkstückträger 2 in Kraftschluß treten können. Durch Druck der Auswerferstifte 42 auf die der ersten Haltevorrichtung 6 zugewandte Fläche 34 des ersten Werkstückträgers 2 ist dieser von der ersten Haltevorrichtung 6 lösbar.

Entsprechend umfaßt im ersten Ausführungsbeispiel nach Fig. 3 die zweite Haltevorrichtung 7 eine zweite Auswurfvorrichtung 44. Diese ist mit einem Druckstempel 45 und Auswerferstiften 46 ausgebildet. Die Auswerferstifte 46 sind durch Ausnehmungen (beispielsweise Bohrungen) 47 in der dem zweiten Werkstückträger 4 zugewandten Fläche 35 geführt, so dass sie mit dem zweiten Werkstückträger 4 in Kraftschluß treten können. Durch Druck der Auswerferstifte 46 auf die der zweiten Haltevorrichtung 7 zugewandte Fläche 35 des zweiten Werkstückträgers 4 ist dieser von der zweiten Haltevorrichtung 7 lösbar. Fig. 3 zeigt das erste Ausführungsbeispiel der erfindungsgemäßen Vorrichtung nach Abschluß des Verfahrensschritts, in dem die Haltevorrichtungen 6, 7 mit den Werkstückträgern 2,4 verbunden werden. Die Anordnung aus Werkstück 1, Werkstückträgern 2, 4 und Haltevorrichtungen 6, 7 wird nun in eine Zugvorrichtung eingebracht, durch die über die Haltevorrichtungen 6, 7 auf die Werkstückträger 2,4 eine zu den Hauptflächen des Werkstücks 1 wenigstens teilweise - im gezeigten Ausrührungsbeispiel vorzugsweise wenigstens nahezu exakt - senkrechte Zugkraft ausgeübt werden kann. Die Wirkung dieser Zugvorrichtung, d.h. die Richtung der Zugkraft, ist in Fig. 3 mit den Pfeilen 48 und 49 schematisch dargestellt.

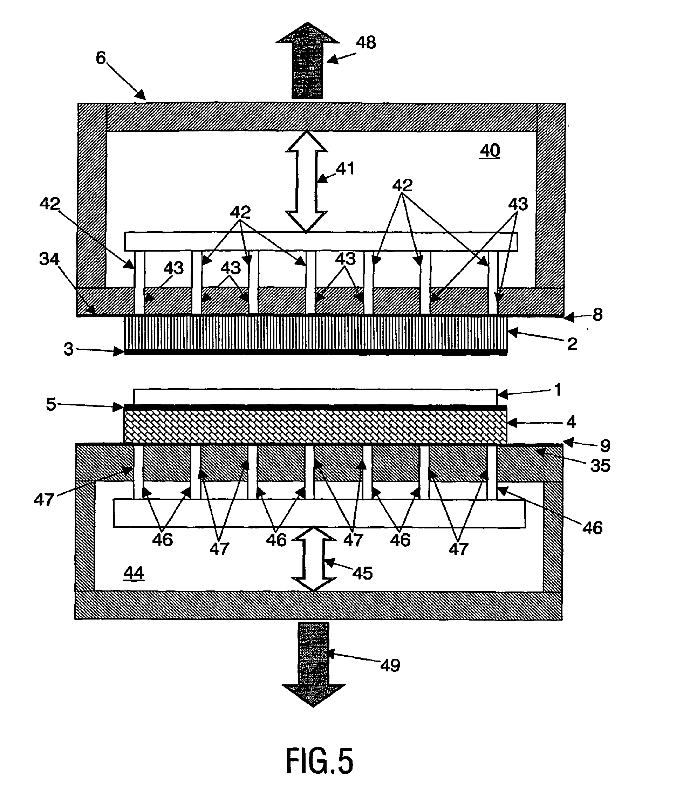

Fig. 5 zeigt die Anordnung nach Fig. 3 im Anschluß an den nächsten Verfahrensschritt, wobei die bereits beschriebenen Elemente wieder mit identischen Bezugszieichen versehen sind Durch die Wirkung der an die Haltevorrichtungen 6 und 7 angelegten Zugkräfte, deren Wirksamkeit durch dunkle Schraffur der Pfeile 48 und 49 angedeutet ist, wird die Konfiguration aus den Haltevorrichtungen 6, 7, den Werkstückträgern 2, 4 und dem Werkstück 1 auseinandergezogen. Dabei löst sich die erste Klebung 3 und von ihr bei Ausbildung mit einer doppelseitig klebenden Folie insbesondere die zweite Klebstoffschicht 16 als die schwächste Verbindung zwischen den genannten Elementen der Anordnung. In Fig. 5 ist der Zustand der Anordnung nach diesem Trennvorgang dargestellt.

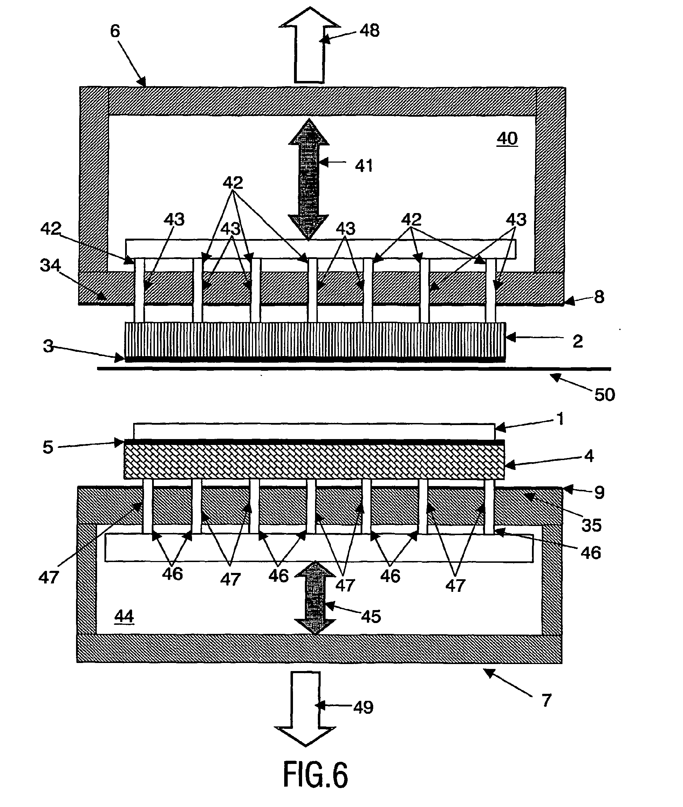

Fig. 6 zeigt schematisch die Durchführung des als nächste Verfahrensschritte im Ausführungsbeispiel der Anordnung nach Fig. 3 und 5 folgenden Trennens der Werkstückträger 2, 4 von den Haltevorrichtungen 6, 7. Dabei sind die bereits beschriebenen Elemente wieder mit denselben Bezugszeichen versehen.

Im ersten der in Fig. 6 erläuterten Verfahrensschritte wird nach diesem Ausführungsbeispiel der erste Werkstückträger 2 von der ersten Haltevorrichtung 6 durch Betätigen des Druckstempels 41 der ersten Auswurfvorrichtung 40 getrennt. Dies ist mit der dunklen Schraffur des Pfeils 41 angedeutet. Der Druckstempel 41 bewegt die Auswerferstifte 42 durch die Ausnehmungen 43 gegen den ersten Werkstückträger 2 und löst dabei die dritte Klebung 8. Ist diese in der beschriebenen Weise als doppelseitig klebende Folie ausgebildet, die auf der Fläche 34 haftet, wird bei diesem Trennvorgang insbesondere die fünfte Klebstoffschicht 25 auf der ersten Fläche 23 dieser Folie gelöst. Die Folie verbleibt dabei auf der ersten Haltevorrichtung 6 und kann für die nächste Verbindung der ersten Haltevorrichtung 6 mit einem (weiteren) ersten Werkstückträger 2 (für ein weiteres Werkstück 1) benutzt werden. Für einen reibungslosen Ablauf dieses Verfahrensschrittes ist die dritte doppelseitig klebende Folie 8 im Bereich der Ausnehmungen 43 entsprechend deren Querschnitt bzw. dem Querschnitt der Auswerferstifte 42 gelocht.

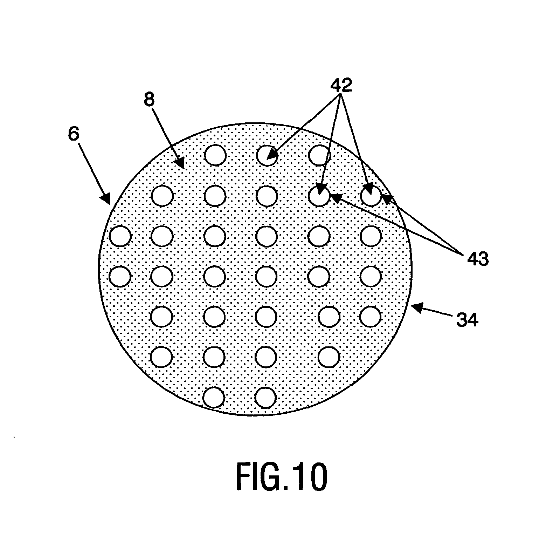

Eine demgemäß ausgebildete Fläche 34 der ersten Haltevorrichtung 6 mit der dritten doppelseitig klebende Folie 8 ist schematisch in Fig. 10 dargestellt, auf die im folgenden noch eingegangen wird.

Die Anordnung nach Fig. 6 umfaßt weiterhin einen Aufnehmer 50 zum Aufnehmen des ersten Werkstückträgers 2 nach dessen Ablösen von der ersten Haltevorrichtung 6. Auf diesem Aufnehmer 50 wird der erste Werkstückträger 2 zur weiteren Verwendung abgelegt.

In der gleichen Weise wie der erste Werkstückträger 2 von der ersten Haltevorrichtung 6 wird auch der zweite Werkstückträger 4 von der zweiten Haltevorrichtung 7 getrennt. Dies zeigt der untere Teil der Fig. 6. In analoger Weise wird dazu die zweite Auswurfvorrichtung 44 mit den in den Ausnehmungen 47 geführten Auswerferstiften 46 durch Betätigen des Druckstempels 45 eingesetzt; die Betätigung ist durch die dunkle Schraffur des Pfeils für den Druckstempel 45 angedeutet. Dabei wird die vierte Klebung 9 gelöst; bei Ausbildung der vierten Klebung 9 als doppelseitig klebende Folie wird bevorzugt deren siebte Klebstoffschicht 30, die sich auf der ersten Fläche 28 der vierten doppelseitig klebenden Folie 9 befindet, aufgetrennt, so dass auch hier die doppelseitig klebende Folie 9 auf der Fläche 35 der zweiten Haltevorrichtung 7 verbleibt. Ein entsprechend dem Aufnehmer 50 ausgebildeter, nicht dargestellter Aufnehmer kann zur Übernahme des von der zweiten.

Haltevorrichtung 7 getrennten zweiten Werkstückträgers 4 mit dem Werkstück 1 eingesetzt werden.

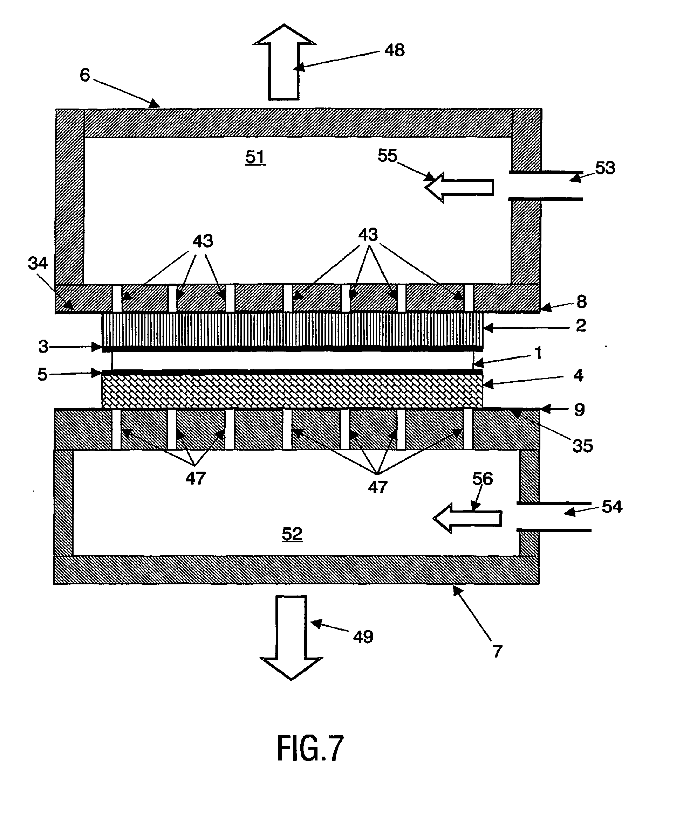

Fig. 7 zeigt in Abwandlung der obigen Anordnung und des damit ausgeführten Verfahrens ein zweites Ausführungsbeispiel der Erfindung. Darin umfassen die Auswurfvorrichtungen der Haltevorrichtungen 6, 7 anstelle der Druckstempel 41, 45 und Auswerferstifte 42, 46 je eine Druckgaseinrichtung 51 bzw. 52, mittels derer die Werkstückträger 2 bzw. 4 durch Druck auf die der Fläche 34 bzw. 35 der jeweiligen Haltevorrichtung 6 bzw. 7 zugewandte Fläche 36 bzw. 39 des ersten bzw. zweiten Werkstückträgers 2 bzw. 4 von der genannten, jeweiligen Haltevorrichtung 6 bzw. 7 getrennt werden. Im übrigen sind bereits erläuterte Elemente der Anordnung nach Fig. 7 wieder mit denselben Bezugszeichen versehen.

Die erste der beiden Druckgaseinrichtungen mit dem Bezugszeichen 51 in der ersten Haltevorrichtung 6 umfaßt einen ersten Druckgasanschluß 53, durch den ein Druckgas, welches im einfachsten Fall aus Preßluft besteht, aber auch eine andere Zusammensetzung haben kann, sofern dies für die Handhabung der Werkstücke erwünscht ist (Schutzgas), in einen als Druckkammer bezeichneten Hohlraum geleitet wird, der in der ersten Haltevorrichtung 6 ausgebildet ist. Diese Druckkammer verbindet den ersten Druckgasanschluß 53 mit den Ausnehmungen 43 in der Fläche 34 der ersten Haltevorrichtung 6, die jetzt als Gasaustrittsöffnungen dienen. Durch einen Pfeil 55 ist die Einleitung von Druckgas und damit die Kraftwirkung auf den ersten Werkstückträger 2 angedeutet.

In gleicher Weise umfaßt die zweite der beiden Druckgaseinrichtungen mit dem Bezugszeichen 52 in der zweiten Haltevorrichtung 7 einen zweiten Druckgasanschluß 54, durch den das Druckgas in eine weitere Druckkammer geleitet wird, die entsprechend in der zweiten Haltevorrichtung 7 ausgebildet ist. Diese weitere Druckkammer verbindet den zweiten Druckgasanschluß 54 mit den jetzt als Gasaustrittsöffnungen dienenden Ausnehmungen 47 in der Fläche 35 der zweiten Haltevorrichtung 7. Durch einen Pfeil 56 ist die Einleitung des Druckgases und damit die Kraftwirkung auf den zweiten Werkstückträger 4 angedeutet.

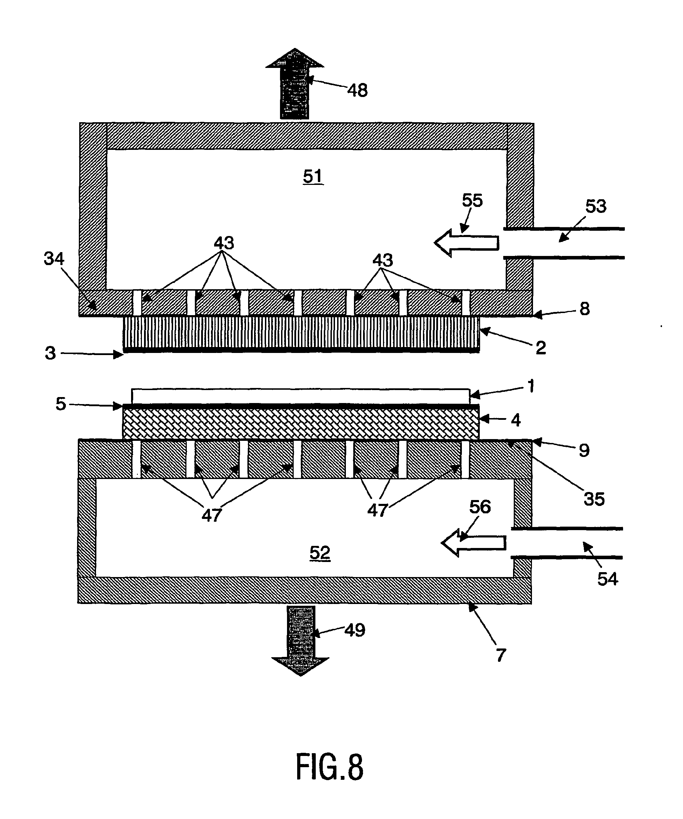

Fig. 8 zeigt die Anordnung nach Fig. 7 im Anschluß an den nächsten Verfahrensschritt, wobei die bereits beschriebenen Elemente wieder mit identischen Bezugszeichen versehen sind. Durch die Wirkung der an die Haltevorrichtungen 6 und 7 angelegten Zugkräfte, deren Wirksamkeit wie im ersten Ausführungsbeispiel nach Fig. 3 durch dunkle Schraffur der Pfeile 48 und 49 angedeutet ist, wird die Konfiguration aus den Haltevorrichtungen 6, 7, den Werkstückträgern 2, 4 und dem Werkstück 1 auseinandergezogen. Dabei löst sich wieder die erste Klebung 3 und von ihr bei Ausbildung mit einer doppelseitig klebenden Folie insbesondere die zweite Klebstoffschicht 16 als die schwächste Verbindung zwischen den genannten Elementen der Anordnung. In Fig. 8 ist der Zustand der Anordnung nach diesem Trennvorgang dargestellt.

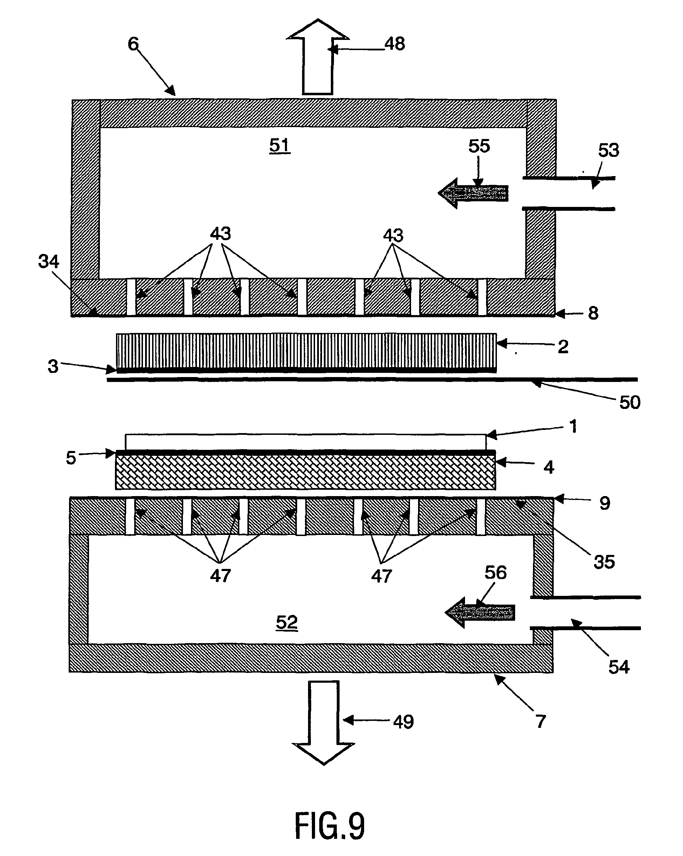

Fig. 9 zeigt schematisch die Durchführung des als nächste Verfahrensschritte im Ausführungsbeispiel der Anordnung nach Fig. 7 und 8 folgenden Trennens der Werkstückträger 2, 4 von den Haltevorrichtungen 6, 7. Dabei sind die bereits beschriebenen Elemente wieder mit denselben Bezugszeichen versehen.

Im ersten der in Fig. 9 erläuterten Verfahrensschritte wird nach diesem Ausführungsbeispiel der erste Werkstückträger 2 von der ersten Haltevorrichtung 6 durch Betätigen der ersten Druckgaseinrichtung 51 getrennt. Dies ist mit der dunklen Schraffur des Pfeils 55 angedeutet. Der Druck des Druckgases wirkt durch die Ausnehmungen 43 auf den ersten Werkstückträger 2 und löst dabei die dritte Klebung 8. Ist diese wieder in der schon beschriebenen Weise als doppelseitig klebende Folie ausgebildet, die auf der Fläche 34 haftet, wird bei diesem Trennvorgang insbesondere die fünfte Klebstoffschicht 25 auf der ersten Fläche 23 dieser Folie gelöst. Die Folie verbleibt dabei auf der ersten Haltevorrichtung 6 und kann für die nächste Verbindung der ersten Haltevorrichtung 6 mit einem (weiteren) ersten Werkstückträger 2 (für ein weiteres Werkstück 1) benutzt werden. Für einen reibungslosen Ablauf dieses Verfahrensschrittes ist die dritte doppelseitig klebende Folie 8 im Bereich der Ausnehmungen 43 entsprechend deren Querschnitt gelocht.

Eine demgemäß ausgebildete Fläche 34 der ersten Haltevorrichtung 6 mit der dritten doppelseitig klebende Folie 8 entspricht in ihrer Gestaltung schematisch der Fig. 10, auf die im folgenden noch eingegangen wird.
Auch die Anordnung nach Fig. 9 umfaßt einen Aufnehmer 50 zum Aufnehmen des ersten Werkstückträgers 2 nach dessen Ablösen von der ersten Haltevorrichtung 6. Auf diesem Aufnehmer 50 wird der erste Werkstückträger 2 zur weiteren Verwendung abgelegt.

In der gleichen Weise wie der erste Werkstückträger 2 von der ersten Haltevorrichtung 6 wird auch bei diesem zweiten Ausführungsbeispiel der zweite Werkstückträger 4 von der zweiten Haltevorrichtung 7 getrennt. Dies zeigt der untere Teil der Fig. 9. In analoger Weise wird dazu die zweite Druckgaseinrichtung 52 eingesetzt; die Betätigung ist durch die dunkle Schraffur des Pfeils 56 angedeutet. Dabei wird die vierte Klebung 9 gelöst; bei Ausbildung der vierten Klebung 9 als doppelseitig klebende Folie wird wieder bevorzugt deren siebte Klebstoffschicht 30, die sich auf der ersten Fläche 28 der vierten doppelseitig klebenden Folie 9 befindet, aufgetrennt, so dass auch hier die doppelseitig klebende Folie 9 auf der Fläche 35 der zweiten Haltevorrichtung 7verbleibt. Ein entsprechend dem Aufnehmer 50 ausgebildeter, nicht dargestellter Aufnehmer kann zur Übernahme des von der zweiten Haltevorrichtung 7 getrennten zweiten Werkstückträgers 4 mit dem Werkstück 1 eingesetzt werden.

Fig. 10 zeigt eine Ausbildung der Fläche 34 der ersten Haltevorrichtung 6 mit der darauf angebrachten dritten doppelseitig klebende Folie 8 sowie den Ausnehmungen 43 für die Auswerferstifte 42. Auch die dritte doppelseitig klebende Folie 8 weist Ausnehmungen auf, deren Lage sich mit derjenigen der Ausnehmungen 43 deckt. Dadurch können die Auswerferstifte 42 Druck auf den ersten Werkstückträger 2 ausüben, ohne die dritte doppelseitig klebende Folie 8 von der Fläche 34 abzulösen.

Entsprechend der Fig. 10 ist auch die zweite Haltevorrichtung 7 mit der Fläche 35 gestaltet, wobei an die Stelle der dritten doppelseitig klebende Folie 8 die vierte doppelseitig klebende Folie 9, an die Stelle der Ausnehmungen 43 die Ausnehmungen 47 und an die Stelle der Auswerferstifte 42 die Auswerferstifte 46 treten.

Eine gleichartige Gestaltung der Flächen 34 bzw. 35 der Haltevorrichtungen 6, 7 ergibt sich auch für das zweite Ausführungsbeispiel, in dem die Druckgaseinrichtungen 51, 52 an die Stelle der Druckstempel 41, 45 und der Auswerferstifte 42, 46 treten. In der Anordnung nach Fig. 10 entfallen dabei die Auswerferstifte 42, 46 in den Ausnehmungen 43 bzw. 47; im übrigen ist die Gestaltung der Flächen 34 bzw. 35 der Haltevorrichtungen 6, 7 grundsätzlich unverändert übernehmbar.

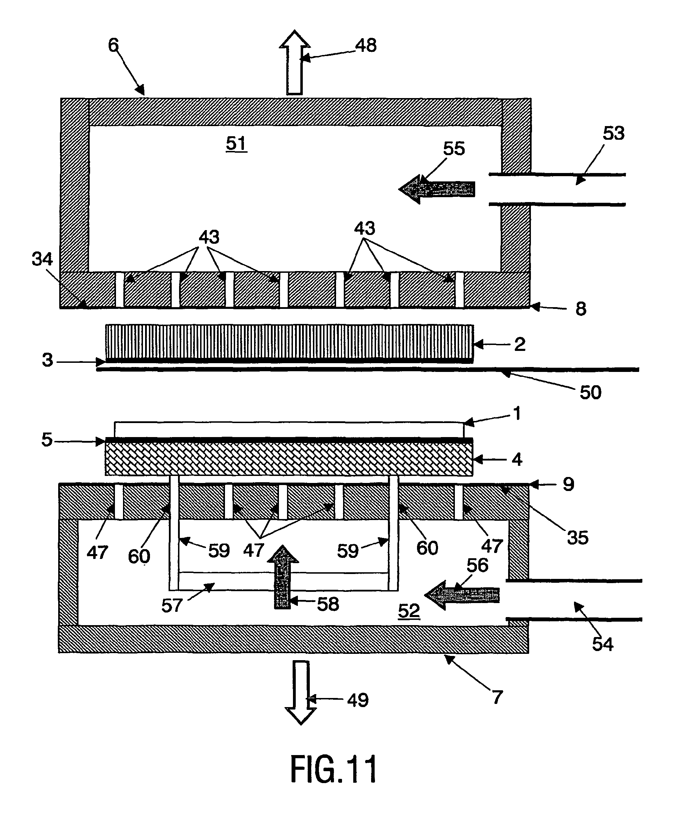

Fig. 11 zeigt eine Abwandlung des in den Figuren 7, 8 und 9 dargestellten zweiten Ausführungsbeispiels der Erfindung, wobei bereits erläuterte Elemente wieder mit übereinstimmenden Bezugszeichen versehen sind Zusätzlich zu den Elementen und damit vorgenommenen Verfahrensschritten des zweiten Ausführungsbeispiels umfaßt die Anordnung gemäß dem vorliegenden, in Fig. 11 dargestellten dritten Ausführungsbeispiel einen zweiten Auswerfer 57, der in Abwandlung der zweiten Auswurfvorrichtung 44, wie sie in den Figuren 3, 5 und 6 des ersten Ausführungsbeispiels dargestellt ist, eine Anzahl von Auswerferstiften 57 umfaßt, die bevorzugt kleiner sein kann als diejenige der Auswerferstifte 46. Die Auswerferstifte 59 sind durch Ausnehmungen 60 geführt. Diese können zusätzlich zu den Ausnehmungen 47 für das Druckgas in der Fläche 35 der zweiten Haltevorrichtung 7 angeordnet sein, oder es kann eine Anzahl der Ausnehmungen 47 als Ausnehmungen 60 für die Auswerferstifte 59 verwendet werden. Die Gestaltung der zweiten Haltevorrichtung 7 entspricht dabei grundsätzlich wieder derjenigen nach Fig. 10.

Der Ablauf der Verfahrensschritte im dritten Ausführungsbeispiel entspricht demjenigen des zweiten Ausführungsbeispiels. Fig. 11 zeigt dieses dritte Ausführungsbeispiel in einem Zustand vergleichbar mit demjenigen nach Fig. 9. Zusätzlich zu den für das zweite Ausführungsbeispiel beschriebenen Verfahrensschritten werden nach dem Trennen des zweiten Werkstückträgers 4 von der zweiten Haltevorrichtung 7 die Auswerferstifte 59 des zweiten Auswerfers 57 ausgefahren, was in Fig. 11 durch den dunkel schraffierten Pfeil 58 angedeutet ist. Dadurch wird der bereits gelöste zweite Werkstückträger 4 von den Auswerferstiften 59 aufgehoben, wobei insbesondere der räumliche Abstand zwischen der Fläche 35 und dem zweiten Werkstückträger 4 auf einfache und definierte Weise vergrößert werden kann, und der zweite Werkstückträger 4 kann, z. B. in der schon erwähnten Weise auf einem zweiten Aufnehmer, von der zweiten Haltevorrichtung 7 entfernt werden.

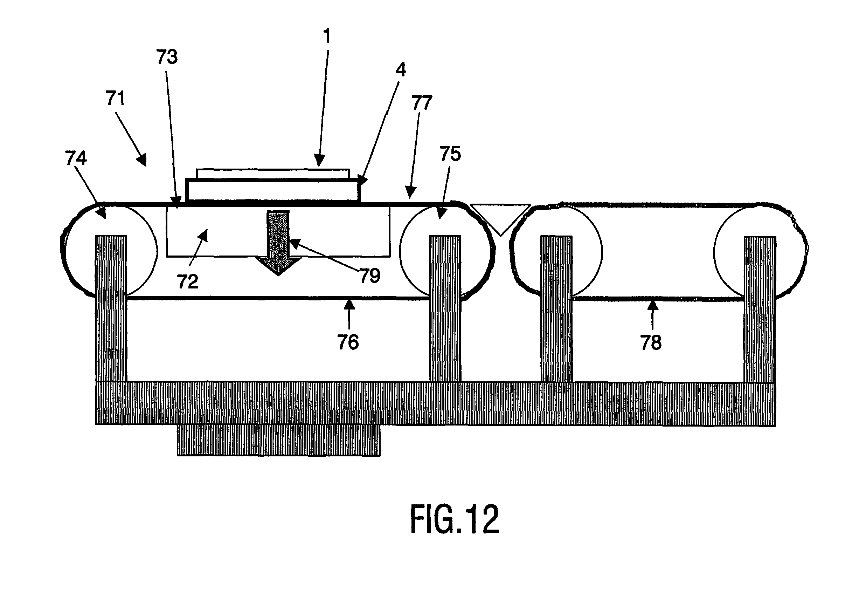

Fig. 12 zeigt in schematischer Darstellung eine Abwandlung für eineAusgestaltung einer Haltevorrichtung am Beispiel der Haltevorrichtung für den zweiten Werkstückträger 4 in Ausbildung mit einer Magnetvorrichtung und flachbandförmigen, abrollbaren Auflageelementen gemäß einem vierten Ausführungsbeispiel. Diese Abwandlung der Haltevorrichtung ist mit dem Bezugszeichen 71 bezeichnet. Die Haltevorrichtung 71 umfaßt einen Elektromagneten 72, auf dessen äußerer, wenigstens weitgehend ebener Fläche 73 ein erstes Laufband 76 - vorzugsweise als Endloslaufband und aus Stahl ausgebildet - aufliegt, welches um zwei Walzen 74, 75 gelegt ist und durch diese abgerollt werden kann. Auf diesem ersten Laufband 76, welches weiterhin vorzugsweise auf seiner dem Elektromagneten 72 abgewandten Fläche mit einer Klebeschicht 77 - beispielsweise als doppelseitig klebende Folie ausgebildet - bedeckt ist, liegt der zweite Werkstückträger 4 mit dem Werkstück 1 auf.

Der zweite Werkstückträger 4 ist dabei mit einem ferromagnetischen Werkstoff ausgebildet, so dass er durch den Elektromagneten 72 angezogen werden kann. In einer Abwandlung dieses Ausführungsbeispiels kann die Haltevorrichtung 71 auch als erste Haltevorrichtung für den ersten Werkstückträger 2 eingesetzt werden. Außerdem besteht die Möglichkeit, die Werkstückträger 2 zw. 4 unter Weglassen des ersten Laufbandes 76 unmittelbar auf der Fläche 73 des Elektromagneten 72 abzusetzen.

Die Verfahrensschritte bei dem vorliegenden vierten Ausführungsbeispiel der Erfindung entsprechen weitgehend denjenigen der vorangehend beschriebenen Ausführungsbeispiele. Eine Variation besteht demgegenüber in der Gestaltung des Verfahrensschrittes des Trennens der Werkstückträger - hier des Werkstückträgers 4 - von den Haltevorrichtungen - hier der (zweiten) Haltevorrichtung 71. Dies ist nachfolgend anhand der Figuren 12 bis 14 dargestellt.

Wie in Fig. 12 gezeigt, ist zum Arretieren des zweiten Werkstückträgers 4 auf der Haltevorrichtung 71 beim Auftrennen der ersten Klebung 3 der Elektromagnet 72 eingeschaltet. Die magnetische Anziehung ist durch einen dunkel schraffierten Pfeil 79 angedeutet. Zusätzlich schafft die Klebeschicht 77 auf dem ersten Laufband eine Fixierung.

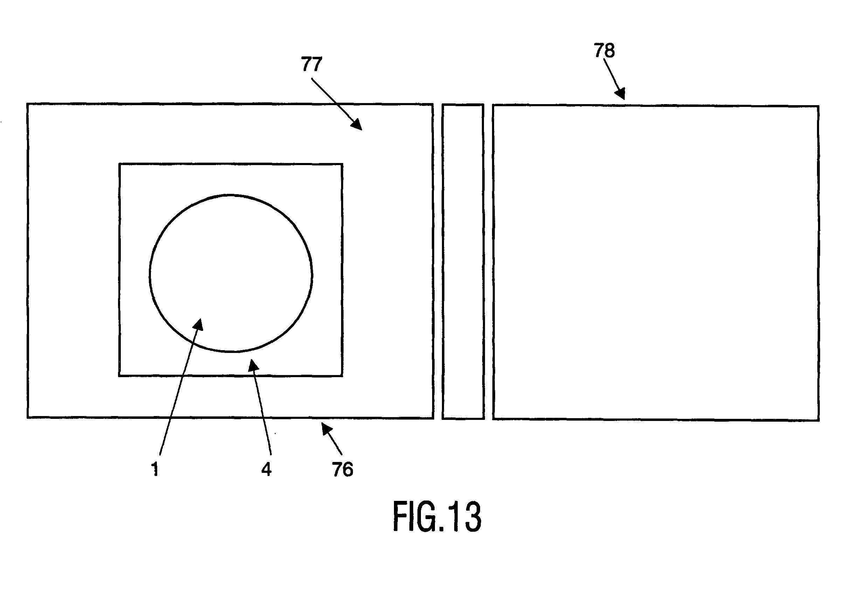

Fig. 13 zeigt die Anordnung mit der Haltevorrichtung 71, dem ersten Laufband 76, dem zweiten Werkstückträger 4 und dem Werkstück 1 in der schematischen Draufsicht.

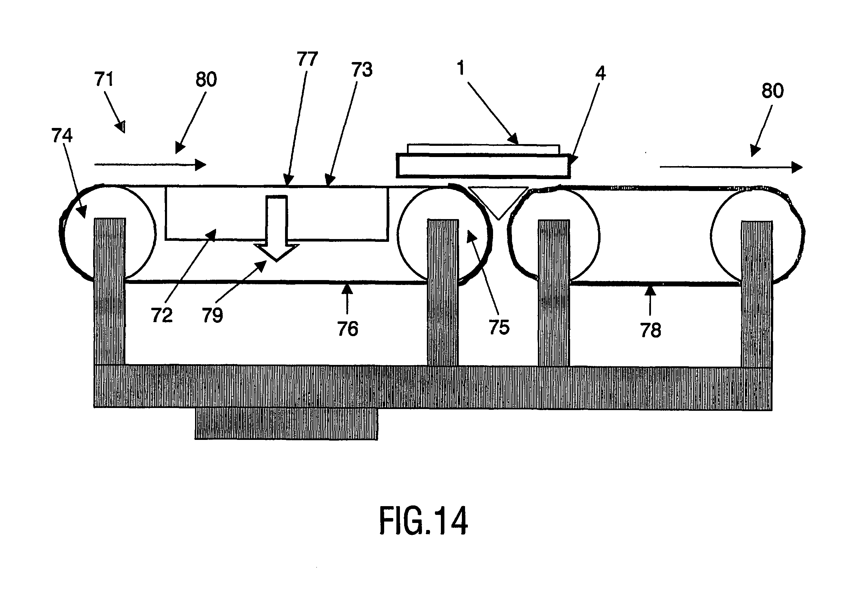

Nach dem Auftrennen der ersten Klebung 3 wird der Elektromagnet 72 gemäß Fig. 14 abgeschaltet und damit der zweite Werkstückträger 4 von der Haltevorrichtung 71 gelöst. Das Abschalten des Elektromagneten 72 ist durch Weglassen der Schraffur des Pfeils 79 in Fig. 14 angedeutet. Zum Trennen des zweiten Werkstückträgers 4 von der Haltevorrichtung 71 wird das erste Laufband 76 abgerollt und damit der zweite Werkstückträger 4 aus dem Wirkungsbereich des Elektromagneten 72 entfernt. Der zweite Werkstückträger 4 wird durch das Abrollen des ersten Laufbandes 76 von diesem herunter und auf ein zweites Laufband 78 befördert, wobei gleichzeitig selbsttätig die Klebeschicht 77 getrennt wird. Das zweite Laufband ist bevorzugt luftdurchlässig und ohne Klebeschicht ausgebildet und dient dem Weitertransport des zweiten Werkstückträgers 4. Die Pfeile 80 bezeichnen die Bewegungsrichtung der Laufbänder 76 und 78 beim Abrollen.

In weiteren Variationen der gezeigten Ausführungsbeispiele können die beschriebenen Verfahren und Vorrichtungen zum Befestigen der Werkstückträger auf den Haltevorrichtungen und zum Trennen der Werkstückträger von den Haltevorrichtungen auch in der Weise kombiniert werden, dass für erste und zweite Haltevorrichtung unterschiedliche Anordnungen und Verfahren benutzt werden. Beispielsweise kann - neben weiteren Möglichkeiten - eine zweite Haltevorrichtung gemäß dem vierten Ausführungsbeispiel nach Fig. 12 bis 14 mit einer ersten Haltevorrichtung gemäß dem zweiten Ausführungsbeispiel nach Fig. 7 bis 9 kombiniert werden.

## Patentansprüche

1. Verfahren zum Umsetzen eines im wesentlichen scheibenförmigen Werkstücks (1) von einem ersten Werkstückträger (4), auf welchem das Werkstück entlang einer ersten seiner Hauptflächen mittels einer ersten Klebung (3) wenigstens weitgehend flächig haftend verbunden ist, auf einen zweiten Werkstückträger (4), umfassend die Verfahrensstufen:
- Befestigen des zweiten Werkstückträgers (4) wenigstens weitgehend flächig haftend auf einer der ersten Hauptfläche des Werkstücks (1) gegenüberliegenden zweiten seiner Hauptflächen mittels einer zweiten Klebung (5), deren Haftkraft deutlich größer ist als die Haftkraft der ersten Klebung,
- Befestigen des ersten Werkstückträgers (2) an einer ersten Haltevorrichtung (6),
weiter **gekennzeichnet durch** die Verfahrensstufen:
- Befestigen des zweiten Werkstückträgers (2) an einer zweiten Haltevorrichtung (6),
- Trennen des mittels der ersten Klebung (3) haftend mit dem ersten Werkstückträger (7) verbundenen Werkstücks (1) vom ersten Werkstückträger (2) entlang der ersten Klebung (3) **durch** Aufbringen einer zu den Hauptflächen des Werkstücks (1) wenigstens teilweise senkrechten Zugkraft (48, 49) zwischen der ersten und der zweiten Haltevorrichtung (6, 7), wobei die erste Klebung (3) beim Aufbringen der Zugkraft (48, 49) zwischen den Haltvorrichtungen (6, 7) aufgetrennt wird, während die zweite Klebung (5) das Werkstück (1) auf dem zweiten Werkstückträger (4) festhält,
- Trennen des ersten Werkstückträgers (2) von der ersten Haltevorrichtung (6),
- Trennen des zweiten Werkstückträgers (4) mitsamt dem damit verbundenen Werkstück (1) von der zweiten Haltevorrichtung (7).

2. Verfahren nach Anspruch 1,
**dadurch gekennzeichnet,**
**dass** als Werkstückträger (6, 7) wenigstens weitgehend starr ausgebildete Werkstückträger verwendet werden.

3. Verfahren nach Anspruch 1 oder 2,
**dadurch gekennzeichnet,**
**dass** die Befestigung des ersten Werkstückträgers (2) an der ersten Haltevorrichtung (6) durch eine dritte Klebung (8) vorgenommen wird, wobei die Haftkraft der dritten Klebung (8) zwischen dem ersten Werkstückträger (2) und der ersten Haltevorrichtung (6) deutlich größer als die Haftkraft der ersten Klebung (3) ist.

4. Verfahren nach Anspruch 1 oder 2,
**dadurch gekennzeichnet,**
**dass** die Befestigung des zweiten Werkstückträgers (4) an der zweiten Haltevorrichtung (7) durch eine vierte Klebung (9) vorgenommen wird, wobei die Haftkraft der vierten Klebung (9) zwischen dem zweiten Werkstückträger (4) und der zweiten Haltevorrichtung (7) deutlich größer als die Haftkraft der ersten Klebung (3) ist.

5. Verfahren nach Anspruch 1 oder 2,
**dadurch gekennzeichnet,**
**dass** der erste Werkstückträger (2) mit ferromagnetischem Werkstoff ausgebildet ist und die Befestigung des ersten Werkstückträgers (2) an der ersten Haltevorrichtung (6) durch eine wahlweise wirksam oder wirkungslos einstellbare erste Magnetvorrichtung vorgenommen wird, die eine magnetische Anziehung zwischen dem ersten Werkstückträger (2) und der ersten Haltevorrichtung (6) mit einer ersten magnetischen Kraft erzeugt, die deutlich größer als die Haftkraft der ersten Klebung (3) ist.

6. Verfahren nach Anspruch 1 oder 2,
**dadurch gekennzeichnet,**
**dass** der zweite Werkstückträger (4) mit ferromagnetischem Werkstoff ausgebildet ist und die Befestigung des zweiten Werkstückträgers (4) an der zweiten Haltevorrichtung (7) durch eine wahlweise wirksam oder wirkungslos einstellbare zweite Magnetvorrichtung vorgenommen wird, die eine magnetische Anziehung zwischen dem zweiten Werkstückträger (4) und der zweiten Haltevorrichtung (7) mit einer zweiten magnetischen Kraft erzeugt, die deutlich größer als die Haftkraft der ersten Klebung (3) ist.

7. Verfahren nach Anspruch 3 oder 4,
**dadurch gekennzeichnet,**
**dass** zum Trennen wenigstens einer der Haltevorrichtungen (6, 7) von dem an ihr befestigten Werkstückträger (2, 4) eine von wenigstens einer dieser Haltevorrichtungen (6, 7) umfaßte Auswurfvorrichtung (44) verwendet wird

8. Verfahren nach Anspruch 7,
**dadurch gekennzeichnet,**
**dass** zum Trennen der Haltevorrichtung (6, 7) von dem an ihr befestigten Werkstückträger (2, 4) eine wenigstens einen Auswerferstift (42 (46), 59) umfassende Auswurfvorrichtung verwendet wird, worin mittels des Auswerferstifts (46) der an dieser Haltevorrichtung (6, 7) befestigte Werkstückträger (2, 4) durch Druck auf diejenige Seite des Werkstückträgers (2, 4), die der Haltevorrichtung (6, 7) zur Befestigung des Werkstückträgers (2, 4) an dieser Haltevorrichtung (6, 7) zugewandt ist, von der Haltevorrichtung (6, 7) gelöst wird.

9. Verfahren nach Anspruch 7,
**dadurch gekennzeichnet,**
**dass** die zum Trennen der Haltevorrichtung (6, 7) von dem an ihr befestigten Werkstückträger (2, 4) eine wenigstens eine Druckgaseinrichtung umfassende Auswurfvorrichtung verwendet wird, worin mittels der Druckgaseinrichtung der an dieser Haltevorrichtung befestigte Werkstückträger durch Druck auf diejenige Seite des Werkstückträgers, die der Haltevorrichtung zur Befestigung des Werkstückträgers an dieser Haltevorrichtung zugewandt ist, von der Haltevorrichtung gelöst wird.

10. Verfahren nach Anspruch 5 oder 6,
**dadurch gekennzeichnet,**
**dass** bei wenigstens einer der Haltevorrichtungen (6, 7), an der das Befestigen des Werkstückträgers (2, 4) mit einer Magnetvorrichtung (72) vorgenommen wird, der Werkstückträger (2, 4) auf einem gegenüber der Magnetvorrichtung bewegbaren, im wesentlichen flächig ausgestalteten Auflageelement (76, 78) angeordnet wird, welches Auflageelement zum Trennen des Werkstückträgers (2, 4) von der Haltevorrichtung (6, 9) gemeinsam mit dem Werkstückträger (2, 4) aus dem Wirkungsbereich der Magnetvorrichtung (72) herausbewegt wird.

11. Verfahren nach Anspruch 10,
**dadurch gekennzeichnet,**
**dass** wenigstens einer der Werkstückträger (6, 7) auf einem abrollbaren, flachbandförmigen, vorzugsweise aus Stahl gebildeten ersten Auflageelement (76) angeordnet wird und der Werkstückträger (2, 4) zum Trennen von der Haltevorrichtung (6, 7) durch Abrollen des flachbandförmigen ersten Auflageelements (76) auf ein flachbandförmiges zweites Auflageelement (78) umgesetzt wird.

12. Verfahren nach Anspruch 1, 4 oder 5,
**dadurch gekennzeichnet,**
**dass** wenigstens eine der Klebungen (3, 5) mit doppelseitig
klebender Folie ausgeführt wird.

13. Vorrichtung zum Durchführen eines Verfahrens nach einem der vorherhegenden Ansprüche zum Umsetzen eines im wesentlichen scheibenförmigen Werkstücks (1) von einem ersten Werkstückträger (2), auf welchem das Werkstück (1) entlang einer ersten seiner Hauptflächen mittels einer ersten Klebung (3) wenigstens weitgehend flächig haftend verbunden ist, auf einen zweiten Werkstückträger (4), auf dem das Werkstück (1) wenigstens weitgehend flächig haftend auf einer der ersten Hauptfläche des Werkstücks (1) gegenüberliegenden zweiten seiner Hauptflächen mittels einer zweiten Klebung (5), deren Haftkraft deutlich größer ist als die Haftkraft der ersten Klebung (3), aufzubringen und zu befestigen ist, eine erste Haltevorrichtung (6) zum Befestigen des ersten Werkstückträgers (2) an dieser ersten Haltevorrichtung (6) und **gekennzeichnet durch** eine zweite Haltevorrichtung (7) zum Befestigen des zweiten Werkstückträgers (4) an dieser zweiten Haltevorrichtung (7) und eine Zugvorrichtung zum Aufbringen einer zu den Hauptflächen des Werkstücks wenigstens teilweise senkrechten Zugkraft (48, 49) zwischen der ersten und zweiten Haltevorrichtung (6, 7).

14. Vorrichtung nach Anspruch 13,
**dadurch gekennzeichnet,**
**dass** das Werkstück (1) ein Erzeugnis der Halbleitertechnik, vorzugsweise eine Halbleiterscheibe, ist, welches entlang wenigstens seiner zweiten Hauptfläche zur Ausbildung einer Anzahl von im wesentlichen senkrecht zu der zweiten Hauptfläche mechanisch zu trennenden, elektronischen Schaltungskörpern gestaltet ist.

15. Vorrichtung nach Anspruch 13 oder 14,
**dadurch gekennzeichnet,**
**dass** die Werkstückträger (2, 4) wenigstens weitgehend starr ausgebildet sind.

16. Vorrichtung nach Anspruch 13, 14 oder 15,
**dadurch gekennzeichnet,**
**dass** die Befestigung des ersten Werkstückträgers (2) an der ersten Haltevorrichtung (6) als dritte Klebung (8) ausgebildet ist, wobei die Haftkraft der dritten Klebung (8) zwischen dem ersten Werkstückträger (2) und der ersten Haltevorrichtung (6) deutlich größer als die Haftkraft der ersten Klebung (3) ist.

17. Vorrichtung nach Anspruch 13, 14 oder 15,
**dadurch gekennzeichnet,**
**dass** die Befestigung des zweiten Werkstückträgers (4) an der zweiten Haltevorrichtung (7) als vierte Klebung (9) ausgebildet ist, wobei die Haftkraft der vierten Klebung (9) zwischen dem zweiten Werkstückträger (4) und der zweiten Haltevorrichtung (7) deutlich größer als die Haftkraft der ersten Klebung (3) ist.

18. Vorrichtung nach Anspruch 13, 14 oder 15,
**gekennzeichnet durch**
eine Ausbildung des ersten Werkstückträgers (2) mit ferromagnetischem Werkstoff sowie **durch** eine wahlweise wirksam, oder wirkungslos einstellbare erste Magnetvorrichtung zum Befestigen des ersten Werkstückträgers (2) an der ersten Haltevorrichtung (6) mit Hilfe einer magnetischen Anziehung zwischen dem ersten Werkstückträger (2) und der ersten Haltevorrichtung (6) mit einer ersten magnetischen Kraft, die deutlich größer als die Haftkraft der ersten Klebung (3) ist.

19. Vorrichtung nach Anspruch 13, 14 oder 15,
**gekennzeichnet durch**
eine Ausbildung des zweiten Werkstückträgers (4) mit ferromagnetischem Werkstoff sowie **durch** eine wahlweise wirksam oder wirkungslos einstellbare zweite Magnetvorrichtung zum Befestigen des zweiten Werkstückträgers (4) an der zweiten Haltevorrichtung (7) mit Hilfe einer magnetischen Anziehung zwischen dem zweiten Werkstückträger (4) und der zweiten Haltevorrichtung (7) mit einer zweiten magnetischen Kraft, die deutlich größer als die Haftkraft der ersten Klebung (3) ist.

20. Vorrichtung nach Anspruch 16 oder 17,
**gekennzeichnet durch**
eine von wenigstens einer der Haltevorrichtungen (6, 7) umfaßte Auswurfvorrichtung zum Trennen wenigstens einer dieser Haltevorrichtungen (6, 7) von dem an ihr befestigten Werkstückträger (2, 4).

21. Vorrichtung nach Anspruch 20,
**dadurch gekennzeichnet,**
**dass** die Auswurfvorrichtung (44) zum Trennen der Haltevorrichtung (6, 7) von dem an ihr befestigten Werkstückträger wenigstens einen Auswerferstift (42, 46, 59) umfaßt, mittels dessen der Werkstückträger (2, 4) durch Druck auf die der Haltevorrichtung (6, 7) zugewandte Seite des Werkstückträgers (2, 4) von dieser Haltevorrichtung (6, 7) lösbar ist.

22. Vorrichtung nach Anspruch 20,
**dadurch gekennzeichnet,**
**dass** die Auswurfvorrichtung zum Trennen der Haltevorrichtung von dem an ihr befestigten Werkstückträger wenigstens eine Druckgaseinrichtung umfaßt, mittels derer der Werkstückträger durch Druck auf die der Haltevorrichtung zugewandte Seite des Werkstückträgers von dieser Haltevorrichtung lösbar ist.

23. Vorrichtung nach Anspruch 18 oder 19,
**dadurch gekennzeichnet,**
**dass** wenigstens eine der mit einer Magnetvorrichtung ausgebildeten Haltevorrichtungen (6, 7) mit einem gegenüber der Magnetvorrichtung (72) bewegbaren, im wesentlichen flächig ausgestalteten, zum Trennen des Werkstückträgers (2, 4) von der Haltevorrichtung (6, 7) gemeinsam mit dem Werkstückträger (2, 4) aus dem Wirkungsbereich der Magnetvorrichtung (72) herausbewegbaren ersten Auflageelement zur Aufnahme des Werkstückträgers ausgestaltet ist.

24. Vorrichtung nach Anspruch 23,
**dadurch gekennzeichnet,**
**dass** das erste Auflageelement (76) bzw. die ersten Auflageelemente flachbandförmig und zum Trennen der Werkstückträger von der Haltevorrichtung (6, 7) bzw. den Haltevorrichtungen abrollbar, vorzugsweise aus Stahl, ausgebildet ist bzw. sind und dass die betreffende Haltevorrichtung (6, 7) mit einem flachbandförmigen zweiten Auflageelement (78) ausgestaltet ist bzw. die betreffenden Haltevorrichtungen mit flachbandförmigen zweiten Auflageelementen ausgestaltet sind, auf welches bzw. welche der Werkstückträger von dem flachbandförmigen ersten Auflageelement durch Abrollen desselben umsetzbar ist.

25. Vorrichtung nach Anspruch 24,
**dadurch gekennzeichnet,**
**dass** wenigstens eines der ersten flachbandförmigen Auflageelemente (76, 78) zum Aufnehmen des Werkstückträgers auf seiner Oberfläche zusätzlich wenigstens teilweise eine Klebeschicht oder eine doppelseitig klebende Folie aufweist.

## Claims

1. A method of transferring a substantially disc-shaped workpiece (1) from a first workpiece carrier (2) on which the workpiece is connected adhesively in at least substantially areal relationship along a first of its main surfaces by means of a first adhesive (3), on to a second workpiece carrier (4), comprising the method steps:
- fixing the second workpiece carrier (4) adhesively in at least substantially areal relationship on a second of the main surfaces of the workpiece (1) in opposite relationship to the first main surface thereof by means of a second adhesive (5), the adhesive force of which is markedly greater than the adhesive force of the first adhesive,
- fixing the first workpiece carrier (2) to a first holding device (6),
further **characterised by** the method steps:
- fixing the second workpiece carrier (4) to a second holding device (6),
- separating the workpiece (1) adhesively connected to the first workpiece carrier (2) by means of the first adhesive (3) from the first workpiece carrier (2) along the first adhesive (3) by application of a tensile force (48, 49) between the first and second holding devices (6, 7), which force is at least partially perpendicular to the main surfaces of the workpiece (1), wherein the first adhesive (3) is pulled open upon application of the tensile force (48, 49) between the holding devices (6, 7) while the second adhesive (5) holds the workpiece (1) fast on the second workpiece carrier (4),
- separating the first workpiece carrier (2) from the first holding device (6), and
- separating the second workpiece carrier (4) together with the workpiece (1) connected thereto from the second holding device (7).

2. A method according to claim 1 **characterised in that** at least substantially rigid workpiece carriers are used as the workpiece carriers (2, 4).

3. A method according to claim 1 or claim 2 **characterised in that** fixing of the first workpiece carrier (2) to the first holding device (6) is effected by a third adhesive (8), the adhesive force of the third adhesive (8) between the first workpiece carrier (2) and the first holding device (6) being markedly greater than the adhesive force of the first adhesive (3).

4. A method according to claim 1 or claim 2 **characterised in that** fixing of the second workpiece carrier (4) to the second holding device (7) is effected by a fourth adhesive (9), the adhesive force of the fourth adhesive (9) between the second workpiece carrier (4) and the second holding device (7) being markedly greater than the adhesive force of the first adhesive (3).

5. A method according to claim 1 or claim 2 **characterised in that** the first workpiece carrier (2) is made with ferromagnetic material and fixing of the first workpiece carrier (2) to the first holding device (6) is effected by a first magnet device which can be selectively set to be operative or inoperative and which produces a magnetic attraction between the first workpiece carrier (2) and the first holding device (6) with a first magnetic force markedly greater than the adhesive force of the first adhesive (3).

6. A method according to claim 1 or claim 2 **characterised in that** the second workpiece carrier (4) is made with ferromagnetic material and fixing of the second workpiece carrier (4) to the second holding device (7) is effected by a second magnet device which can be selectively set to be operative or inoperative and which produces a magnetic attraction between the second workpiece carrier (4) and the second holding device (7) with a second magnetic force markedly greater than the adhesive force of the first adhesive (3).

7. A method according to claim 3 or claim 4 **characterised in that** an ejection device (44) included in at least one of said holding devices (6, 7) is used for separation of at least one of the holding devices (6, 7) from the workpiece carrier (2, 4) fixed thereto.

8. A method according to claim 7 **characterised in that** an ejection device including at least one ejector pin (42 (46), 59) is used for separating the holding device (6, 7) from the workpiece carrier (2, 4) fixed thereto, wherein the workpiece carrier (2, 4) fixed to said holding device (6, 7) is released from the holding device (6, 7) by means of the ejector pin (46) by pressure on that side of the workpiece carrier (2, 4) which is towards the holding device (6, 7) for fixing the workpiece carrier (2, 4) to said holding device (6, 7).

9. A method according to claim 7 **characterised in that** an ejection device including at least one pressure gas device is used for separating the holding device (6, 7) from the workpiece carrier (2, 4) fixed thereto, wherein the workpiece carrier fixed to said holding device is released from the holding device by means of the pressure gas device by pressure on that side of the workpiece carrier which is towards the holding device for fixing the workpiece carrier to said holding device.

10. A method according to claim 5 or claim 6 **characterised in that** in relation to at least one of the holding devices (6, 7) at which fixing of the workpiece carrier (2, 4) is effected with a magnet device (72) the workpiece carrier (2, 4) is arranged on a substantially flat support element (76, 78) movable with respect to the magnet device, the support element being moved out of the region of action of the magnet device (72) jointly with the workpiece carrier (2, 4) for separation of the workpiece carrier (2, 4) from the holding device (6, 9).

11. A method according to claim 10 **characterised in that** at least one of the workpiece carriers (6, 7) is arranged on a first support element (76) which is in the form of a flat belt and which can be rolled away and which is preferably formed from steel and the workpiece carrier (2, 4) is transferred on to a second support element (78) in the form of a flat belt for separation from the holding device (6, 7) by the first support element (76) in the form of the flat belt rolling away.

12. A method according to claim 1, claim 4 or claim 5 **characterised in that** at least one of the adhesives (3, 5) is implemented with double-sided adhesive film.

13. Apparatus for carrying out a method according to one of the preceding claims for transferring a substantially disc-shaped workpiece (1) from a first workpiece carrier (4) on which the workpiece is connected adhesively in at least substantially areal relationship along a first of its main surfaces by means of a first adhesive (3), on to a second workpiece carrier (4), on which the workpiece (1) is to be applied and fixed adhesively in at least substantially areal relationship on a second of the main surfaces of the workpiece (1) in opposite relationship to the first main surface thereof by means of a second adhesive (5), the adhesive force of which is markedly greater than the adhesive force of the first adhesive (3), comprising a first holding device (6) for fixing the first workpiece carrier (2) to said first holding device (6) and **characterised by** a second holding device (7) for fixing the second workpiece carrier (4) to said second holding device (7) and a pulling device for applying a tensile force (48, 49) between the first and second holding devices (6, 7), which force is at least partially perpendicular to the main surfaces of the workpiece.

14. Apparatus according to claim 13 **characterised in that** the workpiece (1) is a semiconductor technology product, preferably a semiconductor wafer, which is designed along at least its second main surface to form a number of electronic circuit bodies to be mechanically separated substantially perpendicularly to the second main surface.

15. Apparatus according to claim 13 or claim 14 **characterised in that** the workpiece carriers (2, 4) are at least substantially rigid.

16. Apparatus according to claim 13, claim 14 or claim 15 **characterised in that** fixing of the first workpiece carrier (2) to the first holding device (6) is effected by a third adhesive (8), the adhesive force of the third adhesive (8) between the first workpiece carrier (2) and the first holding device (6) being markedly greater than the adhesive force of the first adhesive (3).

17. Apparatus according to claim 13, claim 14 or claim 15 **characterised in that** fixing of the second workpiece carrier (4) to the second holding device (7) is effected by a fourth adhesive (9), the adhesive force of the fourth adhesive (9) between the second workpiece carrier (4) and the second holding device (7) being markedly greater than the adhesive force of the first adhesive (3).

18. Apparatus according to claim 13, claim 14 or claim 15 **characterised by** the first workpiece carrier (2) being made of ferromagnetic material and by a first magnet device which can be selectively set to be operable or inoperable for fixing the first workpiece carrier (2) to the first holding device (6) by means of magnetic attraction between the first workpiece carrier (2) and the first holding device (6) with a first magnetic force markedly greater than the adhesive force of the first adhesive (3).

19. Apparatus according to claim 13, claim 14 or claim 15 **characterised by** the second workpiece carrier (4) being made of ferromagnetic material and by a second magnet device which can be selectively set to be operable or inoperable for fixing the second workpiece carrier (4) to the second holding device (7) by means of magnetic attraction between the second workpiece carrier (4) and the second holding device (7) with a second magnetic force markedly greater than the adhesive force of the first adhesive (3).

20. Apparatus according to claim 16 or claim 17 **characterised by** an ejection device included in at least one of the holding devices (6, 7) for separating at least one of said holding devices (6, 7) from the workpiece carrier (2, 4) fixed thereto.

21. Apparatus according to claim 20 **characterised in that** the ejection device (44) for separating the holding device (6, 7) from the workpiece carrier fixed thereto includes at least one ejector pin (42, 46, 59), by means of which the workpiece carrier (2, 4) is releasable from the holding device (6, 7) by pressure on the side of the workpiece carrier (2, 4), that is towards the holding device (6, 7).

22. Apparatus according to claim 20 **characterised in that** the ejection device for separating the holding device from the workpiece carrier fixed thereto includes at least one pressure gas device, by means of which the workpiece carrier is releasable from the holding device by pressure on the side of the workpiece carrier, that is towards the holding device.

23. Apparatus according to claim 18 or claim 19 **characterised in that** at least one of the holding devices (6, 7) which is designed with a magnet device is provided with a first support element for receiving the workpiece carrier, which support element is movable with respect to the magnet device (72) and is of a substantially flat configuration and is movable out of the region of action of the magnet device (72) for separation of the workpiece carrier (2, 4) from the holding device (6, 7) jointly with the workpiece carrier (2, 4).

24. Apparatus according to claim 23 **characterised in that** the first support element (76) or elements is or are in the form of a flat belt and are adapted to be rollable away for separation of the workpiece carriers from the holding device (6, 7) or devices, preferably being of steel, and the holding device (6, 7) in question is provided with a second support element (78) in the form of a flat belt or the corresponding holding devices are provided with second support elements in the form of flat belts, on to which the workpiece carrier can be transferred from the first support element in the form of a flat belt by rolling-away movement thereof.

25. Apparatus according to claim 24 **characterised in that** at least one of the first support elements (76, 78) in the form of flat belts additionally has at least partially an adhesive layer or a double-sided adhesive film on its surface for receiving the workpiece carrier.

## Revendications

1. Procédé de transfert d'une pièce (1) en forme essentiellement de disque d'un premier porte-pièce (4), sur lequel la pièce est reliée en adhérant au moins en grande partie à plat le long d'une première de ses surfaces principales au moyen d'un premier collage (3), à un second porte-pièce (4), comprenant les étapes de procédé suivantes consistant à :
- fixer le second porte-pièce (4) en adhérant au moins en grande partie à plat sur une deuxième de ses surfaces principales opposée à la première surface principale de la pièce (1) au moyen d'un deuxième collage (5), dont la force adhésive est nettement plus grande que la force adhésive du premier collage,
- fixer le premier porte-pièce (2) sur un premier dispositif de retenue (6),
**caractérisé en outre par** les étapes de procédé suivantes consistant à :
- fixer le second porte-pièce (2) sur un second dispositif de retenue (6),
- séparer la pièce (1) reliée de manière adhésive au premier porte-pièce (7) au moyen du premier collage (3) du premier porte-pièce (2) le long du premier collage (3) par application d'une force de traction (48, 49) au moins partiellement verticale par rapport aux surfaces principales de la pièce (1) entre le premier et le second dispositifs de retenue (6, 7), le premier collage (3) étant séparé lors de l'application de la force de traction (48, 49) entre les dispositifs de retenue (6, 7), alors que le deuxième collage (5) retient la pièce (1) sur le second porte-pièce (4),
- séparer le premier porte-pièce (2) du premier dispositif de retenue (6),
- séparer le second porte-pièce (4) avec la pièce (1) reliée à celui-ci du second dispositif de retenue (7).

2. Procédé selon la revendication 1,
**caractérisé en ce**
**que** des portes-pièces réalisés au moins en grande partie de manière rigide sont utilisés comme portes-pièces (6, 7).

3. Procédé selon la revendication 1 ou 2,
**caractérisé en ce**
**que** la fixation du premier porte-pièce (2) sur le premier dispositif de retenue (6) est entreprise par un troisième collage (8), la force adhésive du troisième collage (8) entre le premier porte-pièce (2) et le premier dispositif de retenue (6) étant nettement plus grande que la force adhésive du premier collage (3).

4. Procédé selon la revendication 1 ou 2,
**caractérisé en ce**
**que** la fixation du second porte-pièce (4) sur le second dispositif de retenue (7) est entreprise par un quatrième collage (9), la force adhésive du quatrième collage (9) entre le second porte-pièce (4) et le second dispositif de retenue (7) étant nettement plus grande que la force adhésive du premier collage (3).

5. Procédé selon la revendication 1 ou 2,
**caractérisé en ce**
**que** le premier porte-pièce (2) est réalisé avec du matériau ferromagnétique et la fixation du premier porte-pièce (2) sur le premier dispositif de retenue (6) est entreprise par un premier dispositif magnétique réglable au choix efficacement ou inefficacement qui génère une attraction magnétique entre le premier porte-pièce (2) et le premier dispositif de retenue (6) avec une première force magnétique qui est nettement plus grande que la force adhésive du premier collage (3).

6. Procédé selon la revendication 1 ou 2,
**caractérisé en ce**
**que** le second porte-pièce (4) est réalisé avec du matériau ferromagnétique et la fixation du second porte-pièce (4) sur le second dispositif de retenue (7) est entreprise par un second dispositif magnétique réglable au choix efficacement ou inefficacement qui génère une attraction magnétique entre le second porte-pièce (4) et le second dispositif de retenue (7) avec une seconde force magnétique qui est nettement plus grande que la force adhésive du premier collage (3).

7. Procédé selon la revendication 3 ou 4,
**caractérisé en ce**
**que** pour la séparation d'au moins l'un des dispositifs de retenue (6, 7) du porte-pièce (2, 4) fixé sur lui, un dispositif d'éjection (44) compris par au moins l'un de ces dispositifs de retenue (6, 7) est utilisé.

8. Procédé selon la revendication 7,
**caractérisé en ce**
**que** pour la séparation du dispositif de retenue (6, 7) du porte-pièce (2, 4) fixé sur lui, un dispositif d'éjection comportant au moins une tige d'éjection (42 (46), 59) est utilisé, dans lequel au moyen de la tige d'éjection (46), le porte-pièce (2, 4) fixé sur ce dispositif de retenue (6, 7) est détaché du dispositif de retenue (6, 7) par une pression sur le coté du porte-pièce (2, 4) qui est tourné vers le dispositif de retenue (6, 7) pour la fixation du porte-pièce (2, 4) sur ce dispositif de retenue (6, 7).

9. Procédé selon la revendication 7,
**caractérisé en ce**
**que** pour la séparation du dispositif de retenue (6, 7) du porte-pièce (2, 4) fixé sur lui, un dispositif d'éjection comportant au moins un dispositif à gaz comprimé est utilisé, dans lequel au moyen du dispositif à gaz comprimé, le porte-pièce fixé sur ce dispositif de retenue est détaché du dispositif de retenue par une pression sur le coté du porte-pièce qui est tourné vers le dispositif de retenue pour la fixation du porte-pièce sur ce dispositif de retenue.

10. Procédé selon la revendication 5 ou 6,
**caractérisé en ce**
**que** pour au moins l'un des dispositifs de retenue (6, 7), sur lequel la fixation du porte-pièce (2, 4) est entreprise avec un dispositif aimanté (72), le porte-pièce (2, 4) est disposé sur un élément d'appui (76, 78) configuré essentiellement plan, mobile par rapport au dispositif aimanté, lequel élément d'appui est déplacé pour la séparation du porte-pièce (2, 4) du dispositif de retenue (6, 9) conjointement avec le porte-pièce (2, 4) hors de la zone d'action du dispositif aimanté (72).

11. Procédé selon la revendication 10,
**caractérisé en ce**
**qu'**au moins l'un des portes-pièces (6, 7) est disposé sur un premier élément d'appui (76) déroulable, en forme de bande plate, formé de préférence en acier et le porte-pièce (2, 4) est transféré pour la séparation du dispositif de retenue (6, 7) par déroulement du premier élément d'appui (76) en forme de bande plate à un second élément d'appui (78) en forme de bande plate.

12. Procédé selon la revendication 1, 4 ou 5,
**caractérisé en ce**
**qu'**au moins l'un des collages (3, 5) est réalisé avec un film collant des deux côtés.

13. Dispositif pour effectuer un procédé selon l'une quelconque des revendications précédentes de transfert d'une pièce (1) en forme essentiellement de disque d'un premier porte-pièce (2), sur lequel la pièce (1) est reliée en adhérant au moins en grande partie à plat le long d'une première de ses surfaces principales au moyen d'un premier collage (3), à un second porte-pièce (4), sur lequel la pièce (1) doit être appliquée et fixée en adhérant au moins en grande partie à plat sur une deuxième de ses surfaces principales opposée à la première surface principale de la pièce (1) au moyen d'un deuxième collage (5), dont la force adhésive est nettement plus grande que la force adhésive du premier collage (3), un premier dispositif de retenue (6) pour la fixation du premier porte-pièce (2) sur ce premier dispositif de retenue (6), et
**caractérisé par** un second dispositif de retenue (7) pour la fixation du second porte-pièce (4) sur ce second dispositif de retenue (7) et un dispositif de traction pour l'application d'une force de traction (48, 49) au moins partiellement verticale par rapport aux surfaces principales de la pièce entre le premier et le second dispositifs de retenue (6, 7).

14. Dispositif selon la revendication 13,
**caractérisé en ce**
**que** la pièce (1) est un produit de la technique des semi-conducteurs, de préférence un disque semi-conducteur qui est conçu le long d'au moins sa seconde surface principale pour la réalisation d'un nombre de corps de circuits électroniques, à séparer mécaniquement essentiellement verticalement par rapport à la seconde surface principale.

15. Dispositif selon la revendication 13 ou 14,
**caractérisé en ce**
**que** les portes-pièces (2, 4) sont réalisés au moins essentiellement de manière rigide.

16. Dispositif selon la revendication 13, 14 ou 15,
**caractérisé en ce**
**que** la fixation du premier porte-pièce (2) sur le premier dispositif de retenue (6) est réalisée comme un troisième collage (8), la force adhésive du troisième collage (8) entre le premier porte-pièce (2) et le premier dispositif de retenue (6) étant nettement plus grande que la force adhésive du premier collage (3).

17. Dispositif selon la revendication 13, 14 ou 15,
**caractérisé en ce**
**que** la fixation du second porte-pièce (4) sur le second dispositif de retenue (7) est réalisée comme un quatrième collage (9), la force adhésive du quatrième collage (9) entre le second porte-pièce (4) et le second dispositif de retenue (7) étant nettement plus grande que la force adhésive du premier collage (3).

18. Dispositif selon la revendication 13, 14 ou 15,
**caractérisé par**
une réalisation du premier porte-pièce (2) avec du matériau ferromagnétique ainsi que par un premier dispositif aimanté réglable au choix efficacement ou inefficacement pour la fixation du premier porte-pièce (2) sur le premier dispositif de retenue (6) à l'aide d'une attraction magnétique entre le premier porte-pièce (2) et le premier dispositif de retenue (6) avec une première force magnétique qui est nettement plus grande que la force adhésive du premier collage (3).

19. Dispositif selon la revendication 13, 14 ou 15,
**caractérisé par**
une réalisation du second porte-pièce (4) avec du matériau ferromagnétique ainsi que par un second dispositif aimanté réglable au choix efficacement ou inefficacement pour la fixation du second porte-pièce (4) sur le second dispositif de retenue (7) à l'aide d'une attraction magnétique entre le second porte-pièce (4) et le second dispositif de retenue (7) avec une seconde force magnétique qui est nettement plus grande que la force adhésive du premier collage (3).

20. Dispositif selon la revendication 16 ou 17,
**caractérisé par**
un dispositif d'éjection compris par au moins l'un des dispositifs de retenue (6, 7) pour la séparation d'au moins l'un de ces dispositifs de retenue (6, 7) du porte-pièce (2, 4) fixé sur lui.

21. Dispositif selon la revendication 20,
**caractérisé en ce**
**que** le dispositif d'éjection (44) pour la séparation du dispositif de retenue (6, 7) du porte-pièce fixé sur lui comporte au moins une tige d'éjection (42, 46, 59), au moyen de laquelle le porte-pièce (2, 4) peut être détaché de ce dispositif de retenue (6, 7) par une pression sur le côté tourné vers le dispositif de retenue (6, 7) du porte-pièce (2, 4).

22. Dispositif selon la revendication 20,
**caractérisé en ce**
**que** le dispositif d'éjection pour la séparation du dispositif de retenue du porte-pièce fixé sur lui comporte au moins un dispositif à gaz comprimé, au moyen duquel le porte-pièce peut être détaché de ce dispositif de retenue par une pression sur le côté tourné vers le dispositif de retenue du porte-pièce.

23. Dispositif selon la revendication 18 ou 19,
**caractérisé en ce**
**qu'**au moins l'un des dispositifs de retenue (6, 7) réalisé avec un dispositif aimanté est configuré avec un premier élément d'appui mobile par rapport au dispositif aimanté (72), configuré essentiellement plan, pouvant être déplacé pour la séparation du porte-pièce (2, 4) du dispositif de retenue (6, 7) conjointement avec le porte-pièce (2, 4) hors de la zone d'action du dispositif aimanté (72) pour la réception du porte-pièce.

24. Dispositif selon la revendication 23,
**caractérisé en ce**
**que** le premier élément d'appui (76) ou les premiers éléments d'appui est ou sont réalisés en forme de bande plate et déroulables pour la séparation des portes-pièces du dispositif de retenue (6, 7) ou des dispositifs de retenue, de préférence en acier et en ce que le dispositif de retenue (6, 7) concerné est configuré avec un second élément d'appui (78) en forme de bande plate ou les dispositifs de retenue concernés sont configurés avec des seconds éléments d'appui en forme de bande plate, auquel ou auxquels le porte-pièce peut être transféré du premier élément d'appui en forme de bande plate par déroulement de celui-ci.

25. Dispositif selon la revendication 24,
**caractérisé en ce**
**qu'**au moins l'un des premiers éléments d'appui (76, 78) en forme de bande plate présente pour la réception du porte-outil sur sa surface en outre au moins partiellement une couche de colle ou un film collant des deux côtés.
